# EUROPEAN PATENT APPLICATION

(11) **EP 4 835 577 A1**
(43) Date of publication of application: **04.11.2026**
(21) Application number: 24912721.8
(22) Date of filing: 23.12.2024
(51) Int. Cl.: G03F 7/11, C07F 7/18, G03F 7/004, G03F 7/09, G03F 7/20, G03F 7/38, H01L 21/027

(54) **METHOD FOR PRODUCING LAYERED BODY AND METHOD FOR PRODUCING SEMICONDUCTOR ELEMENT**

(30) Priority: 25.12.2023 JP 2023217679
(71) Applicant: Nissan Chemical Corporation, Tokyo 103-6119 (JP)
(72) Inventor: SAIJO, Taiki, Toyama-shi, Toyama 939-2792 (JP); SHIBAYAMA, Wataru, Toyama-shi, Toyama 939-2792 (JP); FURUKAWA, Yuki, Toyama-shi, Toyama 939-2792 (JP)
(74) Representative: Hoffmann Eitle
(86) International application number: PCT/JP2024/045457
(87) International publication number: WO 2025/142834

(57) **Abstract**

A method for producing a laminate having a surface-modified layer and a semiconductor substrate, the method including: a first step of applying a surface modifier containing a polysiloxane (A) having an organic group having a nitrogen atom and a solvent (B) to the semiconductor substrate, and then baking the semiconductor substrate to form a surface-modified layer precursor; and a second step of bringing the surface-modified layer precursor into contact with a thinning liquid (X) to thin the surface-modified layer precursor and to form a surface-modified layer having a film thickness of 5 nm or less.

## Description

### Technical Field

The present invention relates to a method for producing a laminate, and preferably relates to a method for producing a laminate on which a resist pattern is formed. The present invention also relates to a method for producing a semiconductor element.

### Background Art

In the related art, a lithography process using a resist composition has been performed in the production of semiconductor devices. The degree of integration of semiconductor devices is recently increased, and thus there is a need to miniaturize patterns of wiring or the like. With the miniaturization of patterns, light sources such as far-ultraviolet rays, vacuum ultraviolet rays, electron beams (EB), and X-rays, which have shorter wavelengths, have come to be used. In particular, short-wavelength light such as a KrF excimer laser (wavelength: 248 nm) or an ArF excimer laser (wavelength: 193 nm) has been recently adopted to form a resist pattern.

Along with this, the influence of irregular reflection of active rays from a semiconductor substrate and standing wave becomes a major problem. In order to solve this problem, a method of providing a bottom anti-reflective coating (BARC) between a resist and a semiconductor substrate has been widely studied. In respect of such an anti-reflective coating, many studies have been conducted on an organic anti-reflective coating formed from a composition containing a polymer having a light-absorbing group (chromophore) from the viewpoint of easy use and the like (e.g. Patent Literature 1).

Meanwhile, in respect of extreme ultraviolet rays (EUV, wavelength: 13.5 nm) and electron beams used for the microfabrication technique, there is no problem associated with the reflection from the semiconductor substrate, but there is a problem of resist pattern collapse due to pattern miniaturization. Consequently, a resist underlayer film having high adhesion with a resist has been studied.

### Citation List

### Patent Literature

Patent Literature 1: JP 2008-501985 A

### Summary of Invention

### Technical Problem

A known resist underlayer film has a problem that etching defects such as side etching in an etching step are likely to occur. Therefore, in a case where the substrate surface can be modified with a surface-modified layer having a thin film thickness as compared with the known underlayer film, it can be expected that the adhesion of the photoresist is improved and the photoresist resolution in the advanced lithography process is improved without causing etching defects such as side etching. Furthermore, it is more preferable that the sensitivity of the resist can be increased by providing the surface-modified layer.

However, it is not easy to uniformly form a thin surface-modified layer.

The present invention has been made in view of such circumstances, and an object of the present invention is to provide a method for producing a laminate capable of forming a thin surface-modified layer that can increase the sensitivity of a resist, a method for producing a semiconductor element using the production method, and a laminate having a thin surface-modified layer.

### Solution to Problem

As a result of intensive studies to solve the above problem, the present inventors have found that the above problem can be solved, and completed the present invention having the following gist.

That is, the present invention includes the following items.
[1] A method for producing a laminate having a surface-modified layer and a semiconductor substrate, the method including:
   a first step of applying a surface modifier containing a polysiloxane (A) having an organic group having a nitrogen atom and a solvent (B) to the semiconductor substrate, and then baking the semiconductor substrate to form a surface-modified layer precursor; and
   a second step of bringing the surface-modified layer precursor into contact with a thinning liquid (X) to thin the surface-modified layer precursor and to form the surface-modified layer having a film thickness of 5 nm or less.
[2] The method for producing a laminate according to [1], wherein the nitrogen atom is any one of a nitrogen atom (N¹) constituting an amide bond, a nitrogen atom (N²) constituting a sulfonamide bond, a nitrogen atom (N³) constituting a guanidine structure, and a nitrogen atom (N⁴) other than the N¹ to N³, which is bonded to at least one carbon atom and the bond is a single bond.
[3] The method for producing a laminate according to [1] or [2], wherein the organic group having a nitrogen atom is a group that binds to a silicon atom and is a monovalent group represented by any one of the following formulas (Z1) to (Z4): 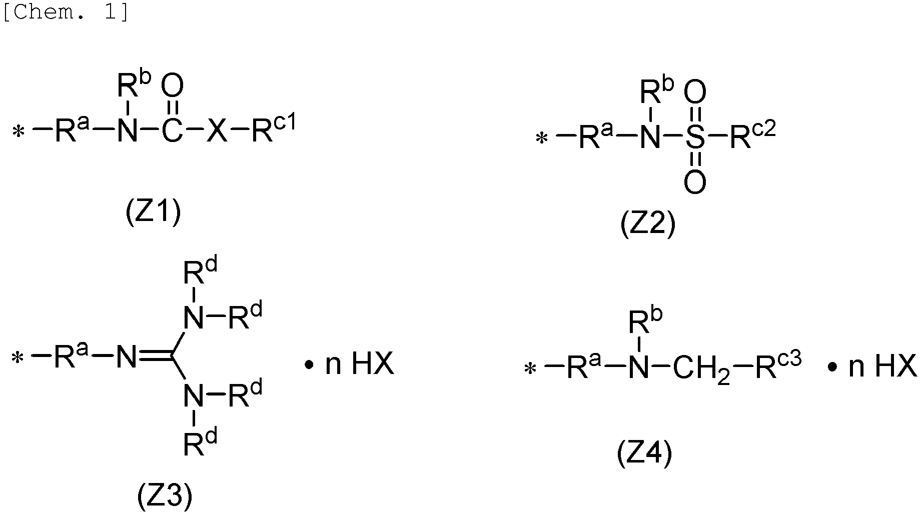
   wherein R^{a} each independently represents a single bond or a divalent group having 1 to 6 carbon atoms;
   R^{b} each independently represents a hydrogen atom or a monovalent group having 1 to 6 carbon atoms;
   R^{c1} to R^{c3} each independently represent a monovalent group having 1 to 20 carbon atoms;
   X represents a single bond, -O- or -N(R^{e})-, where R^{e} represents a hydrogen atom or a monovalent group having 1 to 6 carbon atoms; when X is -N(R^{e})-, R^{e} and R^{c2} may be taken together to form a ring structure having 5 to 7 carbon atoms;
   R^{d} each independently represents a hydrogen atom or a monovalent group having 1 to 20 carbon atoms;
   n each independently represents 0 or a positive number; HX represents an acid; and
   * represents a bond.
[4] The method for producing a laminate according to any one of [1] to [3], wherein the polysiloxane is a hydrolysis condensate of a hydrolyzable silane including a compound represented by the following formula (A): 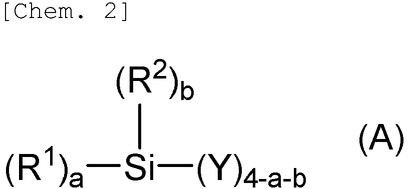
   wherein R¹ is a group bonded to a silicon atom, and each independently represents an organic group having a nitrogen atom;
   R² is a group bonded to a silicon atom, and each independently represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an alkoxy group, an organic group having a sulfonyl group, or an organic group having a cyano group, or a combination of two or more of these groups;
   Y is a group or atom bonded to a silicon atom, and each independently represents an alkoxy group, an aralkyloxy group, an acyloxy group, or a halogen atom;
   a represents an integer of 1 to 3; b represents an integer of 0 to 2; and a+b is 1 to 3.
[5] The method for producing a laminate according to [4], wherein R¹ in the formula (A) is a monovalent group represented by any one of the following formulas (Z1) to (Z4): 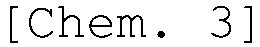 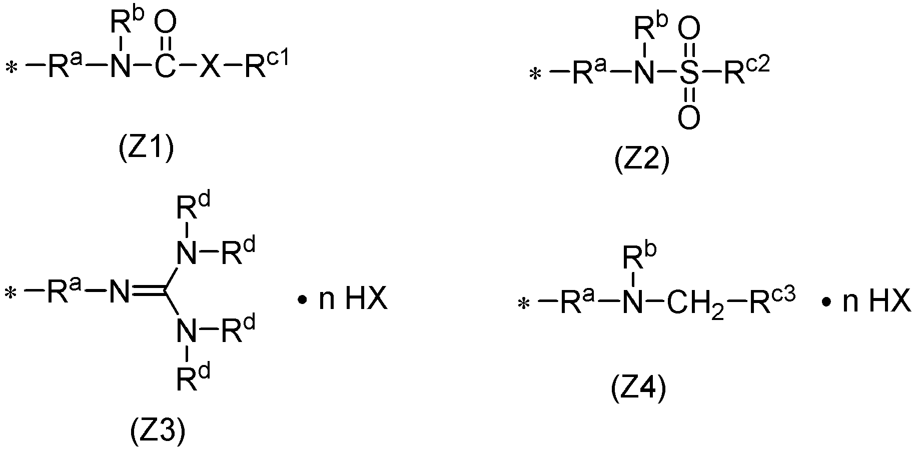
   wherein R^{a} each independently represents a single bond or a divalent group having 1 to 6 carbon atoms;
   R^{b} each independently represents a hydrogen atom or a monovalent group having 1 to 6 carbon atoms;
   R^{c1} to R^{c3} each independently represent a monovalent group having 1 to 20 carbon atoms;
   X represents a single bond, -O- or -N(R^{e})-, where R^{e} represents a hydrogen atom or a monovalent group having 1 to 6 carbon atoms; when X is -N(R^{e})-, R^{e} and R^{c2} may be taken together to form a ring structure having 5 to 7 carbon atoms;
   R^{d} each independently represents a hydrogen atom or a monovalent group having 1 to 20 carbon atoms;
   n each independently represents 0 or a positive number; HX represents an acid; and
   * represents a bond.
[6] The method for producing a laminate according to any one of [1] to [5], wherein the solvent (B) contains at least one selected from the group consisting of a carboxylic acid having a hydroxy group, a linear or cyclic alkyl ketone, a cyclic lactone, an alkylene glycol monoalkyl ether, a monocarboxylic acid ester of an alkylene glycol monoalkyl ether, and an alkoxycarboxylic acid ester of an alkylene glycol monoalkyl ether.
[7] The method for producing a laminate according to any one of [1] to [6], wherein the thinning liquid (X) contains at least one of an organic solvent and water.
[8] The method for producing a laminate according to any one of [1] to [7], wherein the surface modifier further contains a curing catalyst (C).
[9] The method for producing a laminate according to any one of [1] to [8], wherein the semiconductor substrate is a substrate of an inorganic or organic material or a substrate having a film of an inorganic or organic material.
[10] The method for producing a laminate according to [9], wherein the inorganic material is at least one selected from the group consisting of a metal, a metal oxide, a metal nitride, a metal carbide, a metal oxynitride, a metal oxycarbide, and a metal carbonitride.
[11] The method for producing a laminate according to [9], wherein the organic material is at least one selected from the group consisting of amorphous carbon, graphite, fullerene, carbon nanotube, diamond, diamond-like carbon, polyimide, and an organic film in which any one of them is doped or partially substituted with boron, oxygen, nitrogen, phosphorus, silicon, sulfur, or halogen.
[12] The method for producing a laminate according to any one of [1] to [11], wherein the laminate further has a resist underlayer film.
[13] The method for producing a laminate according to any one of [1] to [12], wherein the second step is a step of spin-coating the surface-modified layer precursor with the thinning liquid (X) to thin the surface-modified layer precursor and to form the surface-modified layer having a film thickness of 5 nm or less.
[14] The method for producing a laminate according to any one of [1] to [13], wherein the laminate is used in EUV lithography or electron beam lithography.
[15] The method for producing a laminate according to any one of [1] to [13], wherein the laminate is used in EUV lithography using a metal-containing resist film.
[16] A method for producing a semiconductor element, the method including:
   a step of forming a resist film on the laminate formed by the method for producing a laminate according to any one of [1] to [15]; and
   a step of exposing and developing the resist film to form a resist pattern.
[17] The method for producing a semiconductor element according to [16], wherein the resist film is a metal-containing resist film.
[18] A laminate including: a semiconductor substrate; and a surface-modified layer formed using a surface modifier containing a polysiloxane (A) having an organic group having a nitrogen atom and a solvent (B) and having a film thickness of 5 nm or less.
[19] The laminate according to [18], which is used in EUV lithography or electron beam lithography.
[20] The laminate according to [18], which is used in EUV lithography using a metal-containing resist film.
[21] A surface modifier containing: a polysiloxane (A) having an organic group having a nitrogen atom; and a solvent (B), wherein
   the surface modifier is used in the method for producing a laminate according to any one of [1] to [15].
[22] A compound represented by the following formula (T1): 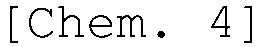 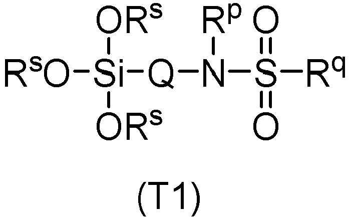
   wherein Q represents a divalent group having 1 to 6 carbon atoms;
   R^{p} represents a hydrogen atom or an alkyl group having 1 to 3 carbon atoms;
   R^{q} represents a monovalent group represented by the following formula (R^{q}-1) or formula (R^{q}-2); and
   R^{s} each independently represents an alkyl group having 1 to 3 carbon atoms, 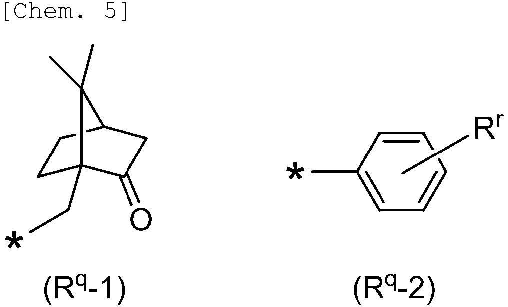
   wherein * each represents a bonding site; and
   in the formula (R^{q}-2), R^{r} represents a perfluoroalkyl group having 1 to 3 carbon atoms, a difluoromethyl group, an iodine atom, an OH group, or a nitro group.

### Advantageous Effects of Invention

According to the present invention, it is possible to provide a method for producing a laminate capable of forming a thin surface-modified layer that can increase the sensitivity of a resist, a method for producing a semiconductor element using the production method, and a laminate having a thin surface-modified layer.

### Description of Embodiments

### (Method for Producing Laminate and Laminate)

The method for producing a laminate of the present invention includes a first step and a second step. The method for producing a laminate of the present invention may further include additional steps.

The first step is a step of applying a surface modifier containing a polysiloxane (A) having an organic group having a nitrogen atom and a solvent (B) to a semiconductor substrate, and then baking the semiconductor substrate to form a surface-modified layer precursor.

The second step is a step of bringing the surface-modified layer precursor into contact with a thinning liquid (X) to thin the surface-modified layer precursor and to form a surface-modified layer having a film thickness of 5 nm or less.

A silicon-containing film is obtained by applying a surface modifier containing a polysiloxane (A) having an organic group having a nitrogen atom and a solvent (B) to a semiconductor substrate, and then baking the semiconductor substrate. However, it is not easy to form a thin film (e.g. a film having a film thickness of 5 nm or less) without film defects such as pinholes and non-uniformity in application only by this step, and it is necessary to sufficiently control application conditions, baking conditions, and the like.

As a result of intensive studies on the method for producing a laminate capable of forming a thin surface-modified layer, the present inventors have found that a thin surface-modified layer can be formed by a first step of forming a layer (surface-modified layer precursor) having a film thickness thicker than a target film thickness and a second step of bringing the layer into contact with a thinning liquid (X) to thin the layer.

When the surface-modified layer precursor obtained from the surface modifier is brought into contact with the thinning liquid (X), the surface-modified layer precursor is not completely removed from the object to be coated, but remains as a thin surface-modified layer on the object to be coated. The present inventors consider that this is related to the interaction of the hydroxy group of the polysiloxane (A) with the object to be coated.

Furthermore, the present inventors have found that when the organic group of the polysiloxane (A) has a nitrogen atom, the sensitivity of the resist film disposed on the surface-modified layer can be increased, leading to the present invention.

A laminate formed by the method for producing a laminate of the present invention includes a surface-modified layer and a semiconductor substrate.

The laminate formed by the method for producing a laminate of the present invention is suitably used in EUV (extreme ultraviolet ray, wavelength: 13.5 nm) lithography or electron beam lithography.

The laminate formed by the method for producing a laminate of the present invention may further have another layer or another film. The other layer is, for example, a resist underlayer film. The resist underlayer film is not particularly limited as long as it is a resist underlayer film used in a lithography process. The resist underlayer film may be, for example, a silicon-containing resist underlayer film or an organic underlayer film. Examples of the organic underlayer film include an organic underlayer film having a high carbon content. The organic underlayer film having a high carbon content is obtained from, for example, a composition containing a novolak resin in a broad sense. Examples of such a composition include a composition for forming a resist underlayer film described in WO 2010/147155 A, WO 2012/077640 A, WO 2013/005797 A, and WO 2017/094780 A.

The resist underlayer film is, for example, an underlayer film of the surface-modified layer. The resist underlayer film is disposed, for example, between the semiconductor substrate and the surface-modified layer.

In the present invention, there is no clear distinction between the film and the layer.

The film thickness of the surface-modified layer is 5 nm or less, preferably 3 nm or less. The lower limit of the film thickness of the surface-modified layer is not particularly limited, and the film thickness of the surface-modified layer may be 0.1 nm or more or 0.2 nm or more.

In the present invention, the film thickness is measured as described below.

The film thickness is measured using an Ellipsometric Film Thickness Measurement System RE-3100 (manufactured by SCREEN Semiconductor Solutions Co., Ltd.).

### <First step>

The first step is a step of forming a surface-modified layer precursor.

In the first step, the semiconductor substrate is coated with the surface modifier and then baked to form a surface-modified layer precursor.

The semiconductor substrate used in the first step is not particularly limited as long as it is, for example, a substrate used for producing a precision integrated circuit element.

Examples of the semiconductor substrate include an inorganic substrate, an organic substrate, a substrate having a film of an inorganic material, and a substrate having a film of an organic material.

Examples of the inorganic material include arsenic, a metal, a metal oxide, a metal nitride, a metal carbide, a metal oxynitride, a metal oxycarbide, and a metal carbonitride. These materials can be used singly or in combination of two or more kinds thereof.

Examples of the metal include silicon, germanium, titanium, tungsten, hafnium, zirconium, chromium, copper, aluminum, indium, gallium, palladium, iron, tantalum, iridium, molybdenum, and alloys of these metals.

Examples of the metal oxide include SiO₂ and TiO₂.

Examples of the metal nitride include SiN, TiN, and TaN.

Examples of the metal carbide include SiC and TiC.

Examples of the metal oxynitride include SiON and TiON.

Examples of the metal oxycarbide include SiOC and TiOC.

Examples of the metal carbonitride include SiCN and TiCN.

Examples of the organic material include amorphous carbon, graphite, fullerene, carbon nanotube, diamond, diamond-like carbon, and polyimide. These materials can be used singly or in combination of two or more kinds thereof. The organic materials described above may be doped or partially substituted with boron, oxygen, nitrogen, phosphorus, silicon, sulfur, or halogen.

Examples of the semiconductor substrate include a semiconductor substrate such as a silicon wafer coated with a silicon oxide film, a silicon nitride film, or a silicon oxynitride film, a silicon nitride substrate, a quartz substrate, a glass substrate (alkali-free glass, low alkali glass, and crystallized glass are included.), a glass substrate on which an indium tin oxide (ITO) film or an indium zinc oxide (IZO) film is formed, a plastic (such as polyimide or PET) substrate, a low-dielectric constant material (low-k material) coated substrate, and a flexible substrate.

The method for applying the surface modifier to the semiconductor substrate is not particularly limited. For example, the surface modifier can be applied by an appropriate applying method such as a spinner or a coater.

The baking after applying the surface modifier to the semiconductor substrate can be performed using, for example, a heating means such as a hot plate.

The baking conditions are appropriately selected from a baking temperature of 40°C to 400°C, or 80°C to 250°C, and a baking time of 0.3 minutes to 60 minutes. Preferably, the baking temperature is 120°C to 250°C, and the baking time is 0.5 minutes to 2 minutes.

The solvent in the surface modifier is evaporated by baking, and a layered precursor of the surface-modified layer is obtained. In some cases, a crosslinking reaction occurs by baking, and a crosslinked layer is obtained. The cross-linking includes partial cross-linking.

The surface-modified layer precursor formed here has a film thickness of, for example, 1 nm to 1,000 nm, or 1 nm to 500 nm, or 1 nm to 300 nm, or 1 nm to 200 nm, or 1 to 150 nm.

### <<Surface Modifier>>

The surface modifier contains a polysiloxane (A) having an organic group having a nitrogen atom and a solvent (B). The surface modifier may further contain an additional component.

The present invention is also directed to the surface modifier used in the method for producing a laminate of the present invention.

### <<<Polysiloxane (A)>>>

The polysiloxane (A) has an organic group having a nitrogen atom.

The organic group having a nitrogen atom is, for example, bonded to a silicon atom.

The number of carbon atoms of the organic group having a nitrogen atom is not particularly limited, and is, for example, 1 to 30.

The nitrogen atom in the organic group having a nitrogen atom is preferably any nitrogen atom of the following N¹ to N⁴ from the viewpoint of suitably obtaining the effect of the present invention.
N¹: nitrogen atom constituting amide bond
N²: nitrogen atom constituting sulfonamide bond
N³: nitrogen atom constituting guanidine structure
N⁴: nitrogen atom other than N¹ to N³ and bonded to at least one carbon atom, the bond being a single bond

The amide bond -N(R)-C(=O)-, wherein R represents a hydrogen atom or a monovalent group, in the description of the polysiloxane (A) includes an amide bond that is a part of a urethane bond and an amide bond that is a part of a urea bond.

The organic group having a nitrogen atom may have or need not have an ionic bond. Examples of the organic group having a nitrogen atom having an ionic bond include an ammonium group and a guanidinium group.

The organic group having a nitrogen atom is preferably a group that binds to a silicon atom and is a monovalent group represented by any one of the following formulas (Z1) to (Z4) from the viewpoint of suitably obtaining the effect of the present invention. 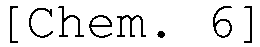 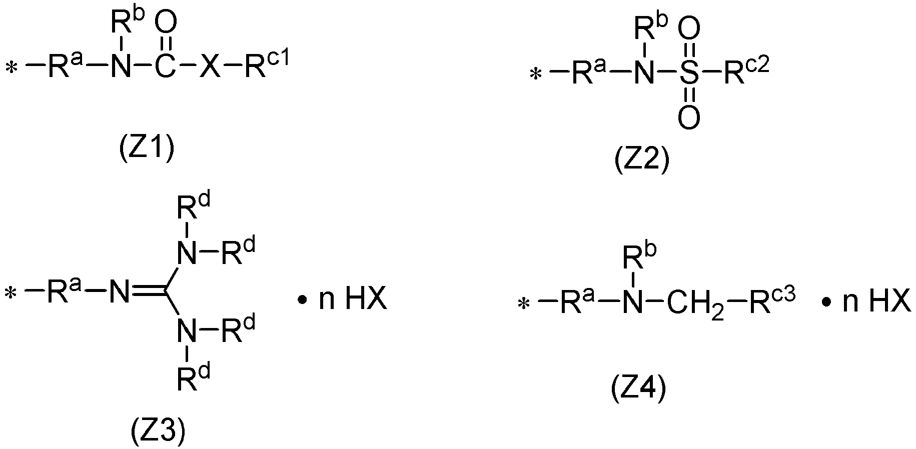
wherein R^{a} each independently represents a single bond or a divalent group having 1 to 6 carbon atoms;
R^{b} each independently represents a hydrogen atom or a monovalent group having 1 to 6 carbon atoms;
R^{c1} to R^{c3} each independently represent a monovalent group having 1 to 20 carbon atoms;
X represents a single bond, -O- or -N(R^{e})-, where R^{e} represents a hydrogen atom or a monovalent group having 1 to 6 carbon atoms; when X is -N(R^{e})-, R^{e} and R^{c2} may be taken together to form a ring structure having 5 to 7 carbon atoms;
R^{d} each independently represents a hydrogen atom or a monovalent group having 1 to 20 carbon atoms;
n each independently represents 0 or a positive number; HX represents an acid; and
* represents a bond.

### -R^{a}-

Examples of the divalent group having 1 to 6 carbon atoms in R^{a} include an alkylene group having 1 to 6 carbon atoms.

Examples of the alkylene group having 1 to 6 carbon atoms include a methylene group, an ethylene group, a propylene group, and a butylene group.

R^{a} is preferably an alkylene group having 1 to 6 carbon atoms.

### -R^{b}-

Examples of the monovalent group having 1 to 6 carbon atoms in R^{b} include an alkyl group having 1 to 4 carbon atoms.

Examples of the alkyl group having 1 to 4 carbon atoms include a methyl group, an ethyl group, a propyl group, and a butyl group.

R^{b} is preferably a hydrogen atom or an alkyl group having 1 to 4 carbon atoms.

### -R^{c1} to R^{c3}-

In R^{c1} to R^{c3}, the monovalent group having 1 to 20 carbon atoms may be linear, branched, cyclic, or a combination of any two or more thereof.

The monovalent group having 1 to 20 carbon atoms may or may not have a hetero atom. Examples of the heteron atom include an oxygen atom, a nitrogen atom, a sulfur atom, and a halogen atom.

In the present description, examples of the halogen atom include a fluorine atom, a chlorine atom, a bromine atom, and an iodine atom.

The monovalent group having 1 to 20 carbon atoms may or may not have a multiple bond. Examples of the multiple bond include a double bond and a triple bond. Examples of the multiple bond include a carbon-carbon double bond, a carbon-oxygen double bond, a carbon-nitrogen double bond, an oxygen-nitrogen double bond, a sulfur-oxygen double bond, a carbon-carbon triple bond, and a carbon-nitrogen triple bond.

The monovalent group having 1 to 20 carbon atoms may or may not have an aromatic ring. Examples of the aromatic ring include an aromatic hydrocarbon ring and an aromatic heterocyclic ring. Examples of the aromatic hydrocarbon ring include benzene, a naphthalene ring, and an anthracene ring. When the monovalent group having 1 to 20 carbon atoms has an aromatic ring, the aromatic ring may or may not have a substituent. Examples of the substituent include a hydroxy group, a nitro group, a halogen atom, an alkyl group having 1 to 6 carbon atoms optionally substituted with a halogen atom, and an alkoxy group having 1 to 6 carbon atoms optionally substituted with a halogen atom.

The monovalent group having 1 to 20 carbon atoms may or may not have an aliphatic ring.

The monovalent group having 1 to 20 carbon atoms may be a residue obtained by removing one hydrogen atom from terpene. The terpene is a compound composed of isoprene as a basic unit. The terpene may have an alcoholic hydroxyl group, a carbonyl group, a carboxy group, or the like.

Examples of the terpene include myrcene, ocimene, limonene, terpineol, pinene, camphor, farnesol, nerolidol, elemene, caryophyllene, and nootkatone.

Examples of R^{c1} and R^{c2} include an alkyl group having 1 to 6 carbon atoms optionally substituted with a halogen atom, a group represented by the following formula (C1), and a group represented by the following formula (C2). 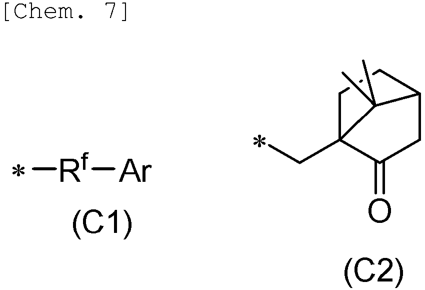 wherein R^{f} represents a single bond or an alkylene group having 1 to 4 carbon atoms; Ar represents a monovalent aromatic group which may have a substituent; and * represents a bond.

Examples of the monovalent aromatic group in Ar include residues obtained by removing one hydrogen atom from the aromatic ring mentioned in the description of the monovalent group having 1 to 20 carbon atoms.

Examples of the substituent in Ar include the substituents mentioned in the description of the monovalent group having 1 to 20 carbon atoms.

Examples of R^{c3} include an alkyl group having 1 to 6 carbon atoms and an alkenyl group having 2 to 6 carbon atoms. Examples of the alkenyl group having 2 to 6 carbon atoms include a vinyl group, an allyl group, a propenyl group, a butenyl group, a hexenyl group, and a cyclohexenyl group.

### -R^{d}-

As the monovalent group having 1 to 20 carbon atoms in R^{d}, an alkyl group having 1 to 4 carbon atoms is preferable, a methyl group and an ethyl group are more preferable, and a methyl group is particularly preferable.

### -R^{e}-

Examples of the monovalent group having 1 to 6 carbon atoms in R^{e} include an alkyl group having 1 to 4 carbon atoms.

As R^{e}, a hydrogen atom or an alkyl group having 1 to 4 carbon atoms is preferable, a hydrogen atom, a methyl group and an ethyl group are more preferable, and a hydrogen atom or a methyl group is particularly preferable.

When X is -N(R^{e})-, R^{e} and R^{c2} may be taken together to form a ring structure having 5 to 7 carbon atoms. Examples of the ring structure having 5 to 7 carbon atoms include a lactam ring having 5 to 7 carbon atoms.

### -n and HX-

In the formulas (Z3) and (Z4), n represents 0 or a positive number.

The upper limit of n is, for example, 3 in the formula (Z3) and 1 in the formula (Z4).

When n is a positive number and the acid is a monovalent acid (for example, methacrylic acid), n represents a positive integer. When the acid is a divalent acid (for example, oxalic acid), n represents a positive integer multiple of 1/2. When the acid is a trivalent acid, n represents a positive integer multiple of 1/3.

HX is not particularly limited as long as it is an acid. Examples of the acid include the acids listed in the item <<<Acid>>> described later. Examples of the acid include an organic acid. Examples of the acid group of the organic acid include a carboxy group and a sulfo group. Examples of the organic acid include sorbic acid, acrylic acid, methacrylic acid, trifluoromethanesulfonic acid, nonafluorobutanesulfonic acid, p-toluenesulfonic acid, phenolsulfonic acid, and 5-sulfosalicylic acid.

In the formulas (Z3) and (Z4), when n is not 0, the formulas (Z3) and (Z4) have a salt structure. In other words, the formula (Z3) and the formula (Z4) each have an ionic bond.

Examples of the method for introducing a salt structure into the formula (Z3) and the formula (Z4) of the polysiloxane include the following methods (I) and (II).
(I): A method of introducing a salt structure into the formula (Z3) and the formula (Z4) of the polysiloxane by adding an acid to a composition containing the polysiloxane having a monovalent group represented by the formula (Z3) or the formula (Z4), wherein n is 0.
(II): A method for obtaining a polysiloxane by hydrolytically condensing a hydrolyzable silane containing a compound represented by the formula (A) described below, wherein R¹ represents a monovalent group represented by any of the formula (Z3) and the formula (Z4), and n represents a positive number.

Examples of the formulas (Z1) to (Z4) include the following groups. 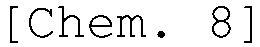 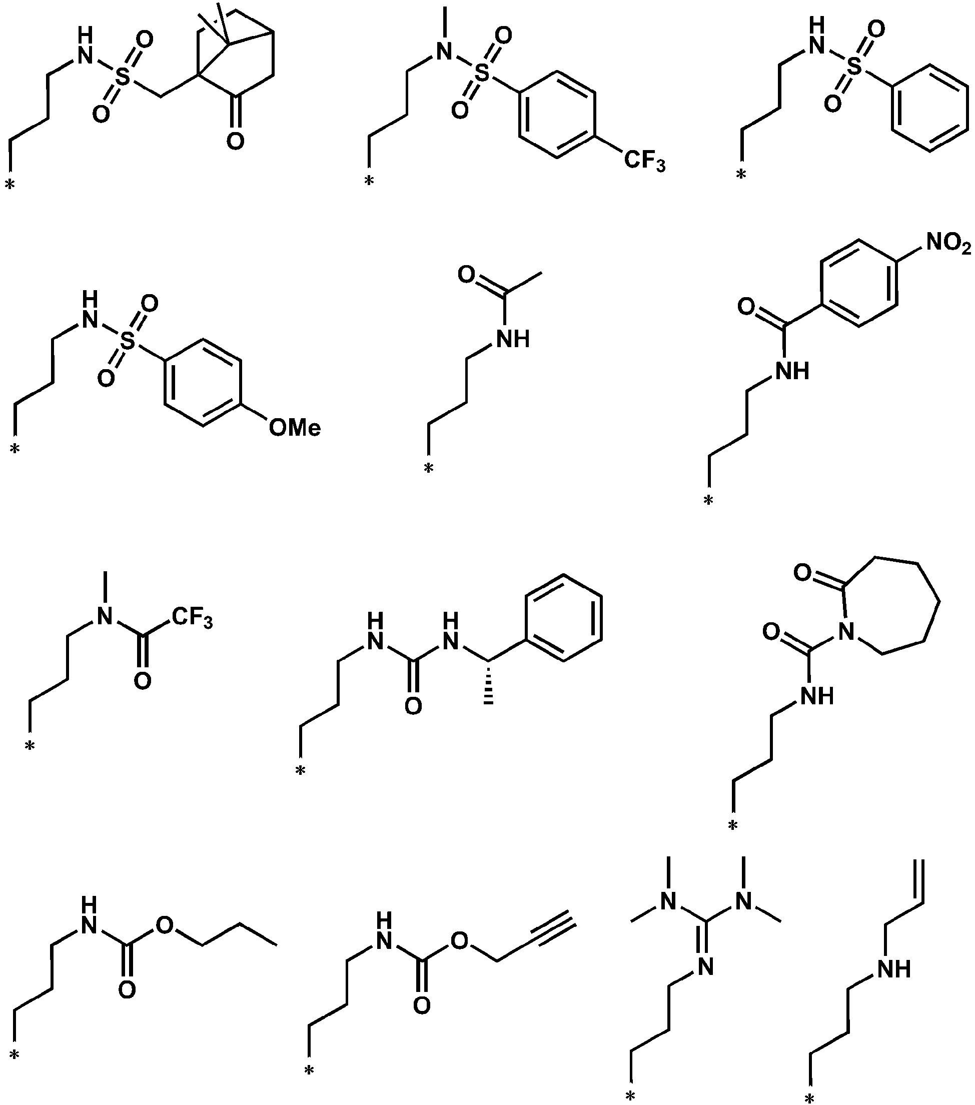 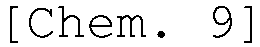 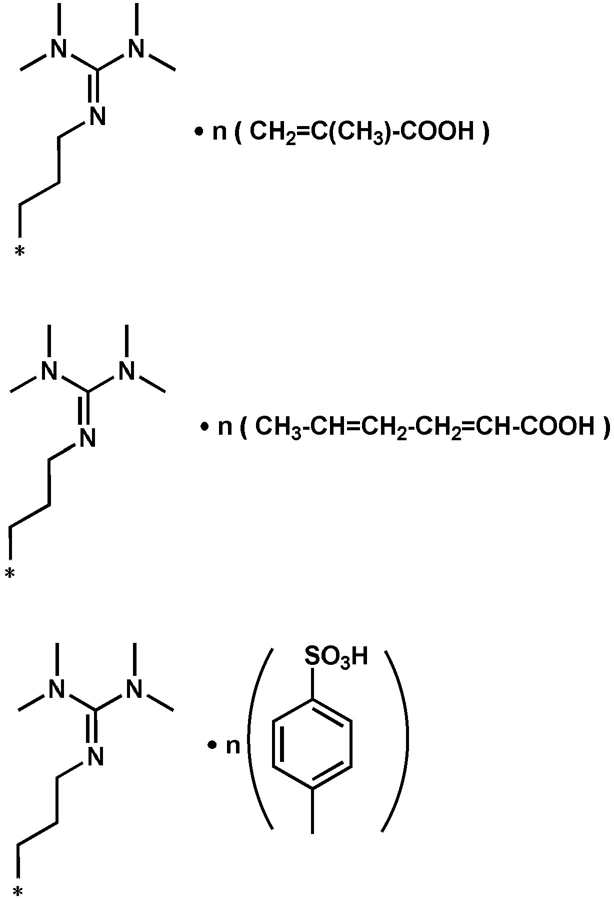 wherein * represents a bond; and Me represents a methyl group.

The polysiloxane is not particularly limited as long as it is a polymer having a siloxane bond.

The polysiloxane may include a modified polysiloxane in which some of silanol groups are modified, for example, a modified polysiloxane in which some of silanol groups are alcohol-modified or acetal-protected.

Further, the polysiloxane may contain, as an example, a hydrolysis condensate of a hydrolyzable silane, and may contain a modified polysiloxane in which at least some of silanol groups of the hydrolysis condensate are alcohol-modified or acetal-protected. The hydrolyzable silane related to the hydrolysis condensate may include one type or two or more types of hydrolyzable silanes.

Further, the polysiloxane may have a structure whose main chain is any of a cage type, a ladder type, a linear type, and a branched type. Furthermore, the polysiloxane to be used may be a commercially available polysiloxane.

The polysiloxane is, for example, a hydrolysis condensate of a hydrolyzable silane containing a compound represented by the following formula (A).

In the present invention, the "hydrolysis condensate", i.e. product of hydrolysis condensation, of the hydrolyzable silane includes not only a polyorganosiloxane polymer which is a condensate prepared through complete condensation, but also a polyorganosiloxane polymer which is a partial hydrolysis condensate prepared through incomplete condensation. Such a partial hydrolysis condensate is a polymer prepared through hydrolysis and condensation of a hydrolyzable silane compound, as in the case of a condensate prepared through complete condensation. However, the partial hydrolysis condensate contains remaining Si-OH groups, due to partial or incomplete hydrolysis and condensation of the silane compound. Further, the surface modifier may contain an uncondensed hydrolysate (complete hydrolysate or partial hydrolysate) or a remaining monomer (hydrolyzable silane), in addition to the hydrolysis condensate.

In the present description, the "hydrolyzable silane" may be simply referred to as "silane compound".

In addition, in the present description, the "polysiloxane" may be referred to as "hydrolysis condensate". 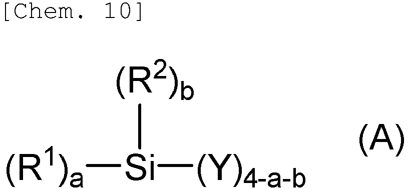
wherein R¹ is a group bonded to a silicon atom, and each independently represents an organic group having a nitrogen atom;
R² is a group bonded to a silicon atom, and each independently represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an alkoxy group, an organic group having a sulfonyl group, or an organic group having a cyano group, or a combination of two or more of these groups;
Y is a group or atom bonded to a silicon atom, and each independently represents an alkoxy group, an aralkyloxy group, an acyloxy group, or a halogen atom;
a represents an integer of 1 to 3; b represents an integer of 0 to 2; and a+b is 1 to 3.

R¹ and R² are not hydrolyzable groups.

R² is a group different from R¹.

a is an integer of 1 to 3, preferably 1 or 2, and more preferably 1.

b is an integer of 0 to 2, preferably 0 or 1, and more preferably 0.

### -R¹-

The nitrogen atom in the organic group having a nitrogen atom in R¹ is preferably any nitrogen atom of the following N¹ to N⁴ from the viewpoint of suitably obtaining the effect of the present invention.
N¹: nitrogen atom constituting amide bond
N²: nitrogen atom constituting sulfonamide bond
N³: nitrogen atom constituting guanidine structure
N⁴: nitrogen atom other than N¹ to N³ and bonded to at least one carbon atom, the bond being a single bond

The organic group having a nitrogen atom in R¹ is preferably a group that binds to a silicon atom and is a monovalent group represented by any one of the above formulas (Z1) to (Z4) from the viewpoint of suitably obtaining the effect of the present invention.

### -R²-

The alkyl group may be linear, branched, or cyclic, and the number of carbon atoms thereof is not particularly limited, but is preferably 40 or less, more preferably 30 or less, still more preferably 20 or less, and even more preferably 10 or less.

Specific examples of the linear or branched alkyl group as the alkyl group include a methyl group, ethyl group, n-propyl group, i-propyl group, n-butyl group, i-butyl group, s-butyl group, t-butyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, and 1-ethyl-2-methyl-n-propyl group.

In the present description, "i" means "iso", "s" means "sec", and "t" means "tert".

Specific examples of the cyclic alkyl group include: cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and crosslinked cyclic cycloalkyl groups, such as a bicyclobutyl group, a bicyclopentyl group, a bicyclohexyl group, a bicycloheptyl group, a bicyclooctyl group, a bicyclononyl group, and a bicyclodecyl group.

The aryl group may be any of a phenyl group, a monovalent group derived by removing one hydrogen atom from a condensed-ring aromatic hydrocarbon compound, and a monovalent group derived by removing one hydrogen atom from a linked-ring aromatic hydrocarbon compound. The number of carbon atoms of the aryl group is not particularly limited, but is preferably 40 or less, more preferably 30 or less, and still more preferably 20 or less.

Examples of the aryl group include an aryl group having 6 to 20 carbon atoms, and examples thereof include, but are not limited thereto, a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, a 1-naphthacenyl group, a 2-naphthacenyl group, a 5-naphthacenyl group, a 2-chrysenyl group, a 1-pyrenyl group, a 2-pyrenyl group, a pentacenyl group, a benzopyrenyl group, and a triphenylenyl group; a biphenyl-2-yl group (o-biphenylyl group), a biphenyl-3-yl group (m-biphenylyl group), a biphenyl-4-yl group (p-biphenylyl group), a paraterphenyl-4-yl group, a metaterphenyl-4-yl group, an orthoterphenyl-4-yl group, a 1,1'-binaphthyl-2-yl group, and a 2,2'-binaphthyl-1-yl group.

The aralkyl group is an alkyl group substituted with an aryl group, and specific examples of the aryl group and the alkyl group are the same as those described above. The number of carbon atoms of the aralkyl group is not particularly limited, but is preferably 40 or less, more preferably 30 or less, and still more preferably 20 or less.

Specific examples of the aralkyl group include, but are not limited to, phenylmethyl group (benzyl group), 2-phenylethylene group, 3-phenyl-n-propyl group, 4-phenyl-n-butyl group, 5-phenyl-n-pentyl group, 6-phenyl-n-hexyl group, 7-phenyl-n-heptyl group, 8-phenyl-n-octyl group, 9-phenyl-n-nonyl group, and 10-phenyl-n-decyl group.

The alkyl halide group, the aryl halide group, and the aralkyl halide group are an alkyl group substituted with one or more halogen atoms, an aryl group substituted with one or more halogen atoms, and an aralkyl group substituted with one or more halogen atoms, respectively. Specific examples of the alkyl group, the aryl group, and the aralkyl group are the same as those described above.

The number of carbon atoms of the alkyl halide group is not particularly limited, but is preferably 40 or less, more preferably 30 or less, still more preferably 20 or less, and yet still more preferably 10 or less.

Specific examples of the alkyl halide group include, but are not limited to, monofluoromethyl group, difluoromethyl group, trifluoromethyl group, bromodifluoromethyl group, 2-chloroethyl group, 2-bromoethyl group, 1,1-difluoroethyl group, 2,2,2-trifluoroethyl group, 1,1,2,2-tetrafluoroethyl group, 2-chloro-1,1,2-trifluoroethyl group, pentafluoroethyl group, 3-bromopropyl group, 2,2,3,3-tetrafluoropropyl group, 1,1,2,3,3,3-hexafluoropropyl group, 1,1,1,3,3,3-hexafluoropropane-2-yl group, 3-bromo-2-methylpropyl group, 4-bromobutyl group, and perfluoropentyl group.

The number of carbon atoms of the aryl halide group is not particularly limited, but is preferably 40 or less, more preferably 30 or less, and still more preferably 20 or less.

Specific examples of the aryl halide group include 2-fluorophenyl group, 3-fluorophenyl group, 4-fluorophenyl group, 2,3-difluorophenyl group, 2,4-difluorophenyl group, 2,5-difluorophenyl group, 2,6-difluorophenyl group, 3,4-difluorophenyl group, 3,5-difluorophenyl group, 2,3,4-trifluorophenyl group, 2,3,5-trifluorophenyl group, 2,3,6-trifluorophenyl group, 2,4,5-trifluorophenyl group, 2,4,6-trifluorophenyl group, 3,4,5-trifluorophenyl group, 2,3,4,5-tetrafluorophenyl group, 2,3,4,6-tetrafluorophenyl group, 2,3,5,6-tetrafluorophenyl group, pentafluorophenyl group, 2-fluoro-1-naphthyl group, 3-fluoro-1-naphthyl group, 4-fluoro-1-naphthyl group, 6-fluoro-1-naphthyl group, 7-fluoro-1-naphthyl group, 8-fluoro-1-naphthyl group, 4,5-difluoro-1-naphthyl group, 5,7-difluoro-1-naphthyl group, 5,8-difluoro-1-naphthyl group, 5,6,7,8-tetrafluoro-1-naphthyl group, heptafluoro-1-naphthyl group, 1-fluoro-2-naphthyl group, 5-fluoro-2-naphthyl group, 6-fluoro-2-naphthyl group, 7-fluoro-2-naphthyl group, 5,7-difluoro-2-naphthyl group, and heptafluoro-2-naphthyl group. Examples thereof also include groups in which fluorine atoms (fluoro groups) in the above groups are optionally substituted with chlorine atoms (chloro groups), bromine atoms (bromo groups), or iodine atoms (iodo groups), but not limited thereto.

The number of carbon atoms of the aralkyl halide group is not particularly limited, but is preferably 40 or less, more preferably 30 or less, and still more preferably 20 or less.

Specific examples of the aralkyl halide group include 2-fluorobenzyl group, 3-fluorobenzyl group, 4-fluorobenzyl group, 2,3-difluorobenzyl group, 2,4-difluorobenzyl group, 2,5-difluorobenzyl group, 2,6-difluorobenzyl group, 3,4-difluorobenzyl group, 3,5-difluorobenzyl group, 2,3,4-trifluorobenzyl group, 2,3,5-trifluorobenzyl group, 2,3,6-trifluorobenzyl group, 2,4,5-trifluorobenzyl group, 2,4,6-trifluorobenzyl group, 2,3,4,5-tetrafluorobenzyl group, 2,3,4,6-tetrafluorobenzyl group, 2,3,5,6-tetrafluorobenzyl group, and 2,3,4,5,6-pentafluorobenzyl group. Examples thereof also include groups in which fluorine atoms (fluoro groups) in the above groups are optionally substituted with chlorine atoms (chloro groups), bromine atoms (bromo groups), or iodine atoms (iodine groups), but not limited thereto.

The alkoxyalkyl group, the alkoxyaryl group, and the alkoxyaralkyl group are an alkyl group substituted with one or more alkoxy groups, an aryl group substituted with one or more alkoxy groups, and an aralkyl group substituted with one or more alkoxy groups, respectively. Specific examples of the alkyl group, the aryl group, and the aralkyl group are the same as those described above.

The alkoxy group as the substituent is, for example, an alkoxy group having at least any one of linear, branched, and cyclic alkyl moieties having 1 to 20 carbon atoms.

Examples of the linear or branched alkoxy group include a methoxy group, an ethoxy group, an n-propoxy group, an i-propoxy group, an n-butoxy group, an i-butoxy group, an s-butoxy group, a t-butoxy group, an n-pentyloxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

Examples of the cyclic alkoxy group include cyclopropoxy group, cyclobutoxy group, 1-methyl-cyclopropoxy group, 2-methyl-cyclopropoxy group, cyclopentyloxy group, 1-methyl-cyclobutoxy group, 2-methyl-cyclobutoxy group, 3-methyl-cyclobutoxy group, 1,2-dimethyl-cyclopropoxy group, 2,3-dimethyl-cyclopropoxy group, 1-ethyl-cyclopropoxy group, 2-ethyl-cyclopropoxy group, cyclohexyloxy group, 1-methyl-cyclopentyloxy group, 2-methyl-cyclopentyloxy group, 3-methyl-cyclopentyloxy group, 1-ethyl-cyclobutoxy group, 2-ethyl-cyclobutoxy group, 3-ethyl-cyclobutoxy group, 1,2-dimethyl-cyclobutoxy group, 1,3-dimethyl-cyclobutoxy group, 2,2-dimethyl-cyclobutoxy group, 2,3-dimethyl-cyclobutoxy group, 2,4-dimethyl-cyclobutoxy group, 3,3-dimethyl-cyclobutoxy group, 1-n-propyl-cyclopropoxy group, 2-n-propyl-cyclopropoxy group, 1-i-propyl-cyclopropoxy group, 2-i-propyl-cyclopropoxy group, 1,2,2-trimethyl-cyclopropoxy group, 1,2,3-trimethyl-cyclopropoxy group, 2,2,3-trimethyl-cyclopropoxy group, 1-ethyl-2-methyl-cyclopropoxy group, 2-ethyl-1-methyl-cyclopropoxy group, 2-ethyl-2-methyl-cyclopropoxy group, and 2-ethyl-3-methyl-cyclopropoxy group.

Specific examples of the alkoxyalkyl group include, but are not limited to, lower (about 5 or less carbon atoms) alkyloxy lower (about 5 or less carbon atoms) alkyl groups, such as methoxymethyl group, ethoxymethyl group, 1-ethoxyethyl group, 2-ethoxyethyl group, and ethoxymethyl group.

Specific examples of the alkoxyaryl group include, but are not limited to, a 2-methoxyphenyl group, 3-methoxyphenyl group, 4-methoxyphenyl group, 2-(1-ethoxy)phenyl group, 3-(1-ethoxy)phenyl group, 4-(1-ethoxy)phenyl group, 2-(2-ethoxy)phenyl group, 3-(2-ethoxy)phenyl group, 4-(2-ethoxy)phenyl group, 2-methoxynaphthalene-1-yl group, 3-methoxynaphthalene-1-yl group, 4-methoxynaphthalene-1-yl group, 5-methoxynaphthalene-1-yl group, 6-methoxynaphthalene-1-yl group, and 7-methoxynaphthalene-1-yl group.

Specific examples of the alkoxyaralkyl group include, but are not limited to, a 3-(methoxyphenyl)benzyl group and a 4-(methoxyphenyl)benzyl group.

The alkenyl group may be linear or branched, and the number of carbon atoms of the linear or branched alkenyl group is not particularly limited, but is preferably 40 or less, more preferably 30 or less, still more preferably 20 or less, and yet still more preferably 10 or less.

Specific examples of the alkenyl group include an ethenyl group (vinyl group), 1-propenyl group, 2-propenyl group, 1-methyl-1-ethenyl group, 1-butenyl group, 2-butenyl group, 3-butenyl group, 2-methyl-1-propenyl group, 2-methyl-2-propenyl group, 1-ethylethenyl group, 1-methyl-1-propenyl group, 1-methyl-2-propenyl group, 1-pentenyl group, 2-pentenyl group, 3-pentenyl group, 4-pentenyl group, 1-n-propylethenyl group, 1-methyl-1-butenyl group, 1-methyl-2-butenyl group, 1-methyl-3-butenyl group, 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4-pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-t-butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, 2-methyl-3-cyclopentenyl group, 2-methyl-4-cyclopentenyl group, 2-methyl-5-cyclopentenyl group, 2-methylene-cyclopentyl group, 3-methyl-1-cyclopentenyl group, 3-methyl-2-cyclopentenyl group, 3-methyl-3-cyclopentenyl group, 3-methyl-4-cyclopentenyl group, 3-methyl-5-cyclopentenyl group, 3-methylene-cyclopentyl group, 1-cyclohexenyl group, 2-cyclohexenyl group, and 3-cyclohexenyl group. Examples thereof also include crosslinked cyclic alkenyl groups such as a bicycloheptenyl group (norbornyl group).

Examples of the substituent in the aforementioned alkyl group, aryl group, aralkyl group, alkyl halide group, aryl halide group, aralkyl halide group, alkoxyalkyl group, alkoxyaryl group, alkoxyaralkyl group, and alkenyl group described above include an alkyl group, an aryl group, an aralkyl group, an alkyl halide group, an aryl halide group, an aralkyl halide group, an alkoxyalkyl group, an aryloxy group, an alkoxyaryl group, an alkoxyaralkyl group, an alkenyl group, an alkoxy group, and an aralkyloxy group. Specific examples thereof and the preferred number of carbon atoms thereof are the same as those described above or below.

The aryloxy group as described in the substituent is a group in which an aryl group is bonded via an oxygen atom (-O-), and specific examples of the aryl group are the same as those described above. The number of carbon atoms in the aryloxy group is not particularly limited, but is preferably 40 or less, more preferably 30 or less, and still more preferably 20 or less. Specific examples thereof include, but are not limited to, a phenoxy group and a naphthalene-2-yloxy group.

When two or more substituents are present, the substituents may be bonded together to form a ring.

Examples of the organic group having an optionally ring-opened epoxy group include a glycidoxymethyl group, a glycidoxyethyl group, a glycidoxypropyl group, a glycidoxybutyl group, an epoxy cyclohexyl group, and groups in which epoxy groups of the above groups are ring-opened.

Examples of the organic group having an acryloyl group include an acryloyloxymethyl group, an acryloyloxyethyl group, and an acryloyloxypropyl group.

Examples of the organic group having a methacryloyl group include a methacryloyloxymethyl group, a methacryloyloxyethyl group, and a methacryloyloxypropyl group.

Examples of the organic group having a mercapto group include a mercaptoethyl group, a mercaptobutyl group, a mercaptohexyl group, a mercaptooctyl group, and a mercaptophenyl group.

Examples of the organic group having an alkoxy group include, but are not limited to, methoxymethyl group and methoxyethyl group. However, the organic group excludes a group in which an alkoxy group is directly bonded to a silicon atom.

Examples of the organic group having a sulfonyl group include, but are not limited to, a sulfonylalkyl group and a sulfonylaryl group.

Examples of the organic group having a cyano group include a cyanoethyl group, a cyanopropyl group, a cyanophenyl group, and a thiocyanate group.

### -Y-

Examples of the alkoxy group in Y include the alkoxy groups exemplified in the description of R².

Examples of the halogen atom in Y include the halogen atom exemplified in the description of R².

The aralkyloxy group is a monovalent group derived by removing a hydrogen atom from a hydroxy group of aralkyl alcohol, and specific examples of the aralkyl group in the aralkyloxy group are the same as those described above.

The number of carbon atoms of the aralkyloxy group is not particularly limited, but may be, for example, 40 or less, preferably 30 or less, and more preferably 20 or less.

Specific examples of the aralkyloxy group include, but are not limited to, a phenylmethyloxy group (benzyloxy group), 2-phenylethyleneoxy group, 3-phenyl-n-propyloxy group, 4-phenyl-n-butyloxy group, 5-phenyl-n-pentyloxy group, 6-phenyl-n-hexyloxy group, 7-phenyl-n-heptyloxy group, 8-phenyl-n-octyloxy group, 9-phenyl-n-nonyloxy group, and 10-phenyl-n-decyloxy group.

The acyloxy group is a monovalent group derived by removing a hydrogen atom from a carboxyl group (-COOH) of a carboxylic acid compound, and examples of the acyloxy group typically include, but are not limited to, alkylcarbonyloxy group, arylcarbonyloxy group, or aralkylcarbonyloxy group, derived by removing a hydrogen atom from a carboxyl group of an alkyl carboxylic acid, an aryl carboxylic acid, or an aralkyl carboxylic acid. Specific examples of the alkyl group, aryl group, and aralkyl group in the alkyl carboxylic acid, aryl carboxylic acid, and aralkyl carboxylic acid are the same as those described above.

Specific examples of the acyloxy group include an acyloxy group having 2 to 20 carbon atoms, and examples thereof include a methylcarbonyloxy group, ethylcarbonyloxy group, n-propylcarbonyloxy group, i-propylcarbonyloxy group, n-butylcarbonyloxy group, i-butylcarbonyloxy group, s-butylcarbonyloxy group, t-butylcarbonyloxy group, n-pentylcarbonyloxy group, 1-methyl-n-butylcarbonyloxy group, 2-methyl-n-butylcarbonyloxy group, 3-methyl-n-butylcarbonyloxy group, 1,1-dimethyl-n-propylcarbonyloxy group, 1,2-dimethyl-n-propylcarbonyloxy group, 2,2-dimethyl-n-propylcarbonyloxy group, 1-ethyl-n-propylcarbonyloxy group, n-hexylcarbonyloxy group, 1-methyl-n-pentylcarbonyloxy group, 2-methyl-n-pentylcarbonyloxy group, 3-methyl-n-pentylcarbonyloxy group, 4-methyl-n-pentylcarbonyloxy group, 1,1-dimethyl-n-butylcarbonyloxy group, 1,2-dimethyl-n-butylcarbonyloxy group, 1,3-dimethyl-n-butylcarbonyloxy group, 2,2-dimethyl-n-butylcarbonyloxy group, 2,3-dimethyl-n-butylcarbonyloxy group, 3,3-dimethyl-n-butylcarbonyloxy group, 1-ethyl-n-butylcarbonyloxy group, 2-ethyl-n-butylcarbonyloxy group, 1,1,2-trimethyl-n-propylcarbonyloxy group, 1,2,2-trimethyl-n-propylcarbonyloxy group, 1-ethyl-1-methyl-n-propylcarbonyloxy group, 1-ethyl-2-methyl-n-propylcarbonyloxy group, phenylcarbonyloxy group, and tosylcarbonyloxy group.

Examples of the compound represented by the formula (A) include compounds (1) to (13) described in Examples described later.

Examples of the compound represented by the formula (A) include a compound represented by the following formula (T1). The compound represented by the formula (T1) is also encompassed by the present invention.

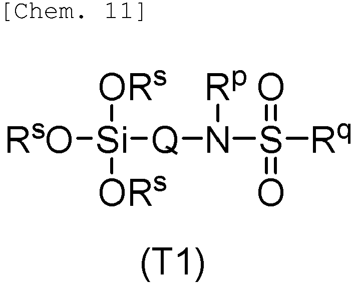

In the formula (T1), Q represents a divalent group having 1 to 6 carbon atoms;
R^{p} represents a hydrogen atom or an alkyl group having 1 to 3 carbon atoms;
R^{q} represents a monovalent group represented by the following formula (R^{q}-1) or formula (R^{q}-2); and
R^{s} each independently represents an alkyl group having 1 to 3 carbon atoms, 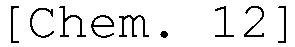 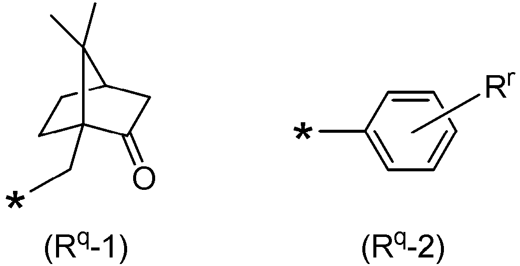
wherein * each represents a bonding site; and
in the formula (R^{q}-2), R^{r} represents a perfluoroalkyl group having 1 to 3 carbon atoms, a difluoromethyl group, an iodine atom, an OH group, or a nitro group.

Examples of the compound represented by the formula (T1) include compounds (1) and (2) described in Examples described later.

The method for synthesizing the compound represented by the formula (T1) is not particularly limited, but for example, the compound can be produced by referring to[0031] to[0040] and Synthesis Examples [(Synthesis of Compound 1) to (Synthesis of Compound 4)] described in Examples in WO 2011/033965 A.

The compound represented by the formula (T1) is obtained by, for example, reacting a compound represented by the following formula (T1-1) with a compound represented by the following formula (T1-2).

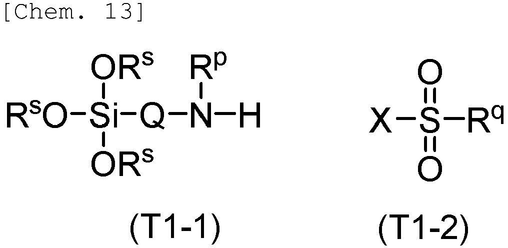

In the formula (T1-1), Q, R^{p}, and R^{s} have the same meanings as Q, R^{p}, and R^{s} in the formula (T1), respectively.

In the formula (T1-2), R^{q} has the same meaning as R^{q} in the formula (T1). X represents a halogen atom.

The hydrolyzable silane in obtaining the polysiloxane may contain, for example, a compound represented by the following formula (1) in addition to the compound represented by the formula (A). That is, the polysiloxane may be a hydrolysis condensate of a hydrolyzable silane containing a compound represented by the formula (A) and a compound represented by the following formula (1):
[Chem. 14]

(R¹¹)ₖ-Si-(R¹²)₄₋ₖ (1)

wherein R¹¹ is a group bonded to a silicon atom, and each independently represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an alkoxy group, an organic group having a sulfonyl group, or an organic group having a cyano group, or a combination of two or more of these groups;
R¹² is a group or atom bonded to a silicon atom, and each independently represents an alkoxy group, an aralkyloxy group, an acyloxy group, or a halogen atom; and
k represents an integer of 0 to 3.

R¹¹ is not a hydrolyzable group.

Specific examples of R¹¹ include the specific examples mentioned in the description of R² in the formula (A).

Specific examples of R¹² include the specific examples mentioned in the description of Y in the formula (A).

### -- Specific examples of hydrolyzable silane represented by the formula (1) --

Specific examples of the hydrolyzable silane represented by the formula (1) include tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxypropylvinyldimethoxysilane, γ-glycidoxypropylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldiacetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, dimethoxymethyl-3-(3-phenoxypropylthiopropyl)silane, triethoxy((2-methoxy-4-(methoxymethyl)phenoxy)methyl)silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltriacetoxysilane, ethoxybenzyltrichlorosilane, i-propoxyphenyltrimethoxysilane, i-propoxyphenyltriethoxysilane, i-propoxyphenyltriacetoxysilane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyltrimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanatopropyltriethoxysilane, chloromethyltrimethoxysilane, chloromethyltriethoxysilane, triethoxysilylpropyldiallyl isocyanurate, bicyclo[2,2,1]heptenyltriethoxysilane, benzenesulfonylpropyltriethoxysilane, benzenesulfonamidopropyltriethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, methylvinyldiethoxysilane, and silanes represented by the following formulas (A-1) to (A-41), but are not limited thereto.

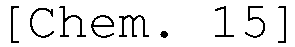

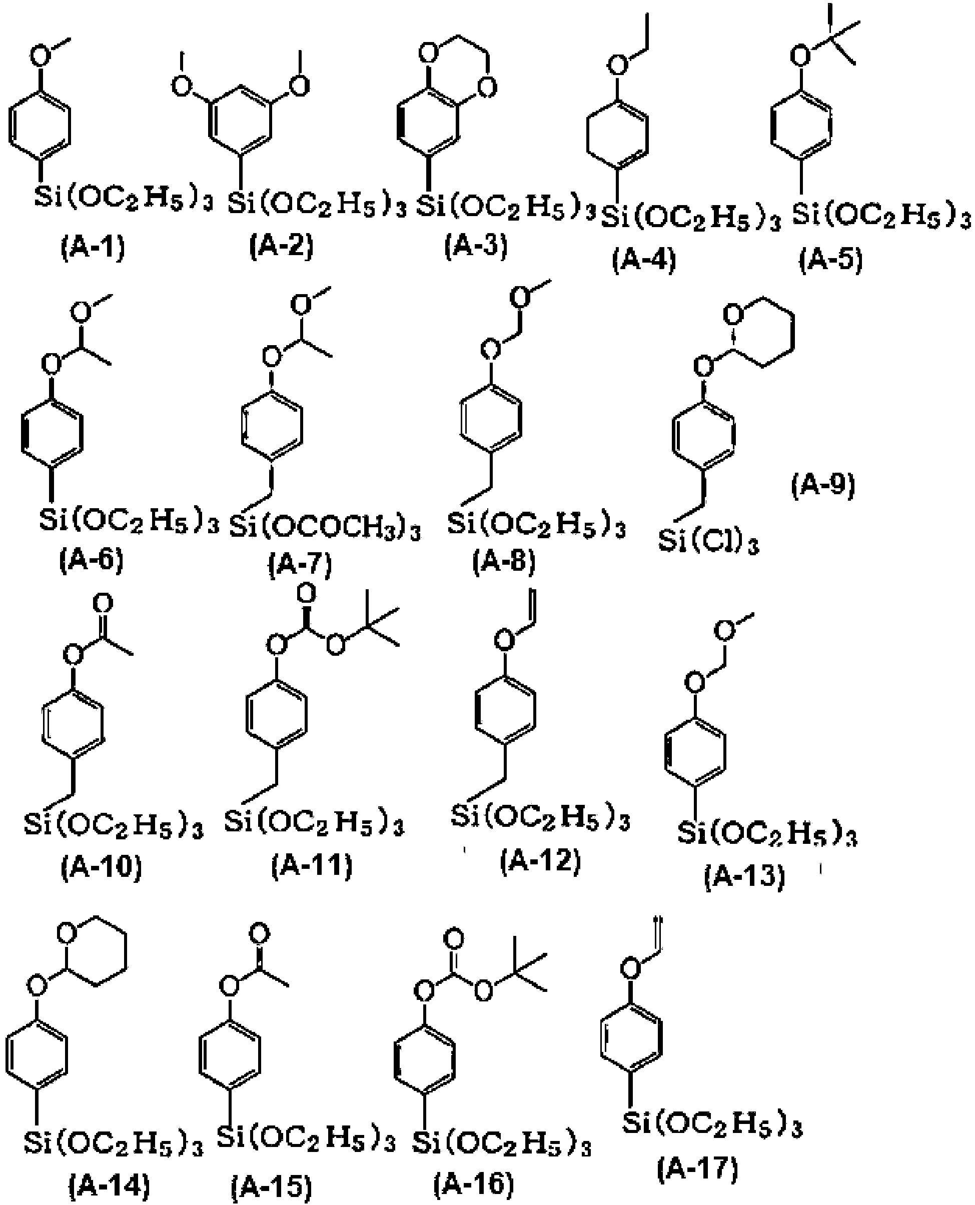

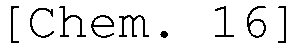

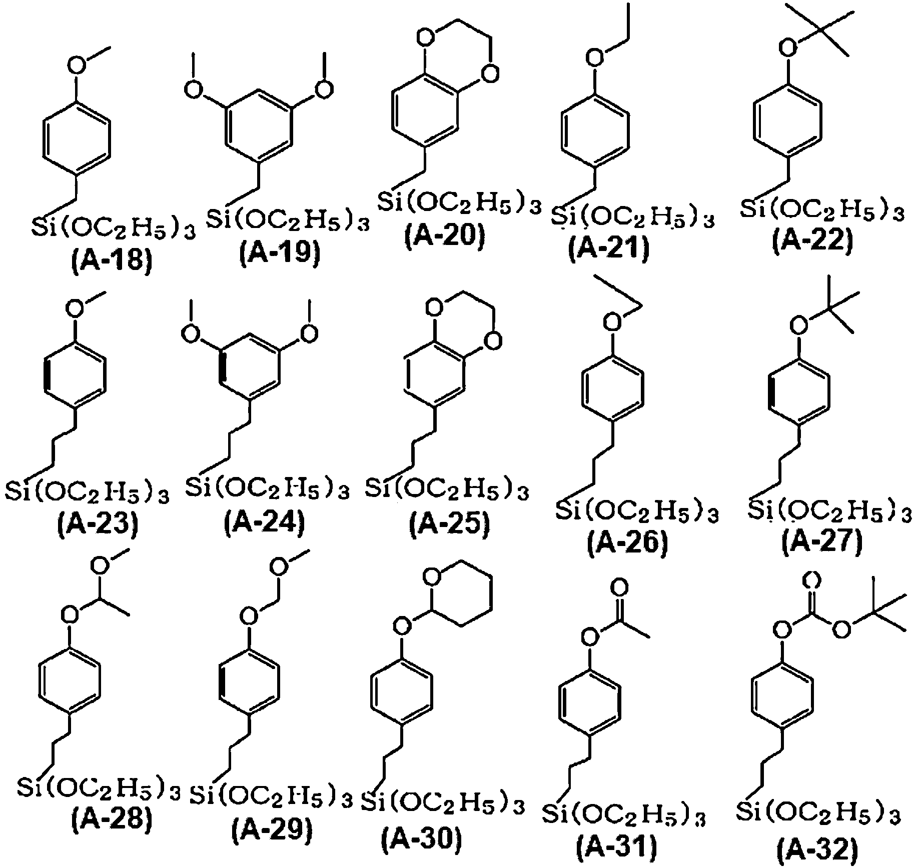

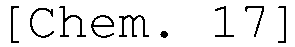

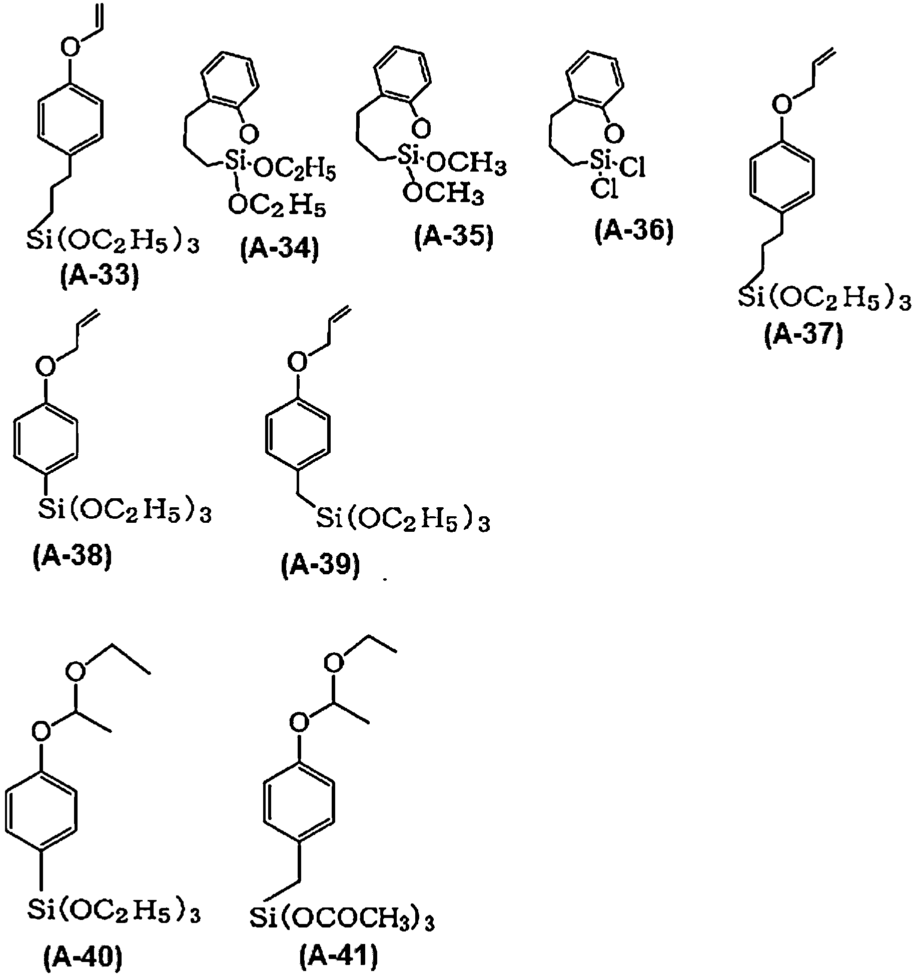

The polysiloxane which is a hydrolysis condensate may be a hydrolysis condensate of a hydrolyzable silane containing a silane compound other than those exemplified above as long as the effects of the present invention are not impaired.

As described above, as the polysiloxane, a modified polysiloxane in which at least some of silanol groups are modified can be used. For example, a polysiloxane modified product in which some of silanol groups are alcohol-modified or acetal-protected can be used.

Examples of the polysiloxane as the modified product include a reaction product obtained by a reaction between at least some of silanol groups and a hydroxy group of an alcohol in the hydrolysis condensate of the hydrolyzable silane described above, a dehydration reaction product between the condensate and an alcohol, and a modified product obtained by protecting at least some of silanol groups of the condensate with an acetal group.

As the alcohol, a monohydric alcohol can be used. Examples of the monohydric alcohol include methanol, ethanol, 2-propanol, 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, and cyclohexanol.

For example, alkoxy group-containing alcohols such as 3-methoxybutanol, ethylene glycol monomethyl ether, ethylene glycol monoethyl ether, diethylene glycol monomethyl ether, diethylene glycol monoethyl ether, propylene glycol monomethyl ether (1-methoxy-2-propanol), propylene glycol monoethyl ether (1-ethoxy-2-propanol), and propylene glycol monobutyl ether (1-butoxy-2-propanol) can be used.

The reaction between silanol groups of the condensate and hydroxy groups of the alcohol is performed by bringing the polysiloxane into contact with the alcohol. A modified polysiloxane containing capped silanol groups is prepared by performing the reaction at a temperature of 40 to 160°C, e.g. 60°C, for 0.1 to 48 hours, e.g. 24 hours. In this case, the alcohol serving as a capping agent may be used as a solvent in the composition containing the polysiloxane.

A dehydration reaction product of a polysiloxane formed of a hydrolysis condensate of a hydrolyzable silane and an alcohol can be produced by allowing the polysiloxane to react with an alcohol in the presence of an acid as a catalyst, capping a silanol group with the alcohol, and removing water generated by dehydration to the outside of the reaction system.

As the acid, an organic acid having an acid dissociation constant (pka) of -1 to 5, preferably 4 to 5 can be used. Examples of the acid include trifluoroacetic acid, maleic acid, benzoic acid, isobutyric acid, and acetic acid, and among them, benzoic acid, isobutyric acid, acetic acid, and the like can be exemplified.

As the acid, an acid having a boiling point of 70 to 160°C may be used. Examples of the acid include trifluoroacetic acid, isobutyric acid, acetic acid, and nitric acid.

As described above, the acid preferably has a physical property of an acid dissociation constant (pka) of 4 to 5 or a boiling point of 70 to 160°C. That is, the acid to be used may be an acid having a weak acidity, or an acid having a low boiling point even when the acidity is high.

Either of these properties: acid dissociation constant and boiling point of the acid may be utilized.

The acetal protection of silanol groups of the condensate can be performed with a vinyl ether; for example, a vinyl ether represented by the following formula (5). Such a reaction can be performed to introduce a partial structure represented by the following formula (6) into the polysiloxane.

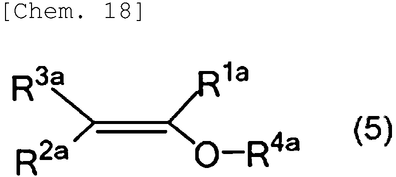

In the formula (5), R^{1a}, R^{2a}, and R^{3a} each represent a hydrogen atom or an alkyl group having 1 to 10 carbon atoms, R^{4a} represents an alkyl group having 1 to 10 carbon atoms, and R^{2a} and R^{4a} may be bonded together to form a ring. Examples of the alkyl group include the examples described above.

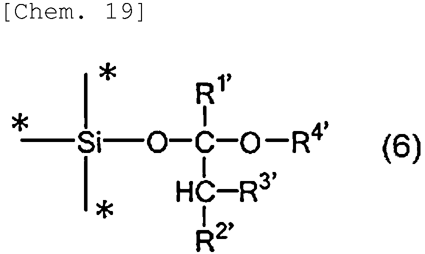

In the formula (6), R¹', R²', and R³' each represent a hydrogen atom or an alkyl group having 1 to 10 carbon atoms, R⁴' represents an alkyl group having 1 to 10 carbon atoms, and R²' and R⁴' may be bonded together to form a ring. In the formula (6), each asterisk * represents a bond to an adjacent atom. The adjacent atom is, for example, an oxygen atom of a siloxane bond, an oxygen atom of a silanol group, or a carbon atom derived from R¹ of the formula (1). Examples of the alkyl group include the examples described above.

As the vinyl ether represented by the formula (5), for example, aliphatic vinyl ether compounds, such as methyl vinyl ether, ethyl vinyl ether, isopropyl vinyl ether, normal butyl vinyl ether, 2-ethylhexyl vinyl ether, tert-butyl vinyl ether, and cyclohexyl vinyl ether; and cyclic vinyl ether compounds, such as 2,3-dihydrofuran, 4-methyl-2,3-dihydrofuran, and 3,4-dihydro-2H-pyran, may be used. In particular, ethyl vinyl ether, propyl vinyl ether, butyl vinyl ether, ethylhexyl vinyl ether, cyclohexyl vinyl ether, 3,4-dihydro-2H-pyran, or 2,3-dihydrofuran may be preferably used.

The acetal protection of silanol groups can be performed using a polysiloxane, a vinyl ether, and an aprotic solvent such as propylene glycol monomethyl ether acetate, ethyl acetate, dimethylformamide, tetrahydrofuran, or 1,4-dioxane as a solvent, and a catalyst such as pyridinium p-toluenesulfonate, trifluoromethanesulfonic acid, p-toluenesulfonic acid, methanesulfonic acid, hydrochloric acid, or sulfuric acid.

The capping of silanol groups with an alcohol or the acetal protection of silanol groups may be performed simultaneously with the hydrolysis and condensation of the hydrolyzable silane described below.

In a preferred aspect of the present invention, the polysiloxane includes at least one of a hydrolysis condensate of a hydrolyzable silane and a modified product thereof, the hydrolyzable silane including a compound represented by the formula (A) and, if desired, a compound represented by the formula (1) and other hydrolyzable silanes.

In a preferred aspect, the polysiloxane includes a dehydration reaction product of a hydrolysis condensate and an alcohol.

The polysiloxane: the hydrolysis condensate of the hydrolyzable silane (which may also include a modified product) may have a weight-average molecular weight of, for example, 500 to 1,000,000. From the viewpoint of preventing the precipitation of the hydrolysis condensate in the composition, the weight-average molecular weight is preferably 500,000 or less, more preferably 250,000 or less, and still more preferably 100,000 or less. From the viewpoint of the compatibility between storage stability and application property, the weight-average molecular weight may be preferably 500 or more, more preferably 600 or more.

The weight-average molecular weight is determined by GPC analysis in terms of polystyrene. The GPC analysis can be performed using, for example, a GPC apparatus (trade name: HLC-8220GPC, manufactured by Tosoh Corporation), a GPC column (trade name: Shodex (registered trademark) KF803L, KF802, KF801, manufactured by Showa Denko K.K.), at a column temperature of 40°C, with tetrahydrofuran as an eluent (elution solvent), at a flow amount (flow rate) of 1.0 mL/min, with polystyrene (Shodex (registered trademark) manufactured by Showa Denko K.K.) as a standard sample.

The hydrolysis condensate of hydrolyzable silane is prepared by hydrolysis and condensation of the above-described silane compound (hydrolyzable silane).

The above-described silane compound (hydrolyzable silane) contains an alkoxy group, aralkyloxy group, acyloxy group, or halogen atom directly bonded to a silicon atom; i.e. an alkoxysilyl group, an aralkyloxysilyl group, an acyloxysilyl group, or a silyl halide group (hereinafter, such a group is referred to as "hydrolyzable group").

For the hydrolysis of the hydrolyzable group, ordinarily 0.1 to 100 mol, for example, 0.5 to 100 mol, preferably 1 to 10 mol, of water is used per mol of the hydrolyzable group.

During hydrolysis and condensation, a hydrolysis catalyst may be used for the purpose of promoting the reaction. Alternatively, the hydrolysis and condensation may be performed without use of a hydrolysis catalyst. When a hydrolysis catalyst is used, the amount of the hydrolysis catalyst is ordinarily 0.0001 to 10 mol, preferably 0.001 to 1 mol per mol of the hydrolyzable group.

The reaction temperature for the hydrolysis and condensation is ordinarily equal to or higher than room temperature, and equal to or lower than the reflux temperature at normal pressure of an organic solvent usable for hydrolysis. The reaction temperature may be, for example, 20 to 110°C, or, for example, 20 to 80°C.

The hydrolysis may be performed completely; i.e. all hydrolyzable groups may be converted into silanol groups, or may be performed partially; i.e. unreacted hydrolyzable groups may remain.

Examples of the hydrolysis catalyst usable for the hydrolysis and condensation include a metal chelate compound, an organic acid, an inorganic acid, an organic base, and an inorganic base.

Examples of the metal chelate compound as the hydrolysis catalyst include, but are not limited to, titanium chelate compounds such as triethoxy-mono(acetylacetonate)titanium, tri-n-propoxy-mono(acetylacetonate)titanium, tri-i-propoxy-mono(acetylacetonate)titanium, tri-n-butoxy-mono(acetylacetonate)titanium, tri-sec-butoxy-mono(acetylacetonate)titanium, tri-t-butoxy-mono(acetylacetonate)titanium, diethoxy-bis(acetylacetonate)titanium, di-n-propoxy-bis(acetylacetonate)titanium, di-i-propoxy-bis(acetylacetonate)titanium, di-n-butoxy-bis(acetylacetonate)titanium, di-sec-butoxy-bis(acetylacetonate)titanium, di-t-butoxy-bis(acetylacetonate)titanium, monoethoxy-tris(acetylacetonate)titanium, mono-n-propoxy-tris(acetylacetonate)titanium, mono-i-propoxy-tris(acetylacetonate)titanium, mono-n-butoxy-tris(acetylacetonate)titanium, mono-sec-butoxy-tris(acetylacetonate)titanium, mono-t-butoxy-tris(acetylacetonate)titanium, tetrakis(acetylacetonate)titanium, triethoxy-mono(ethyl acetoacetate)titanium, tri-n-propoxy-mono(ethyl acetoacetate)titanium, tri-i-propoxy-mono(ethyl acetoacetate)titanium, tri-n-butoxy-mono(ethyl acetoacetate)titanium, tri-sec-butoxy-mono(ethyl acetoacetate)titanium, tri-t-butoxy-mono(ethyl acetoacetate)titanium, diethoxy-bis(ethyl acetoacetate)titanium, di-n-propoxy-bis(ethyl acetoacetate)titanium, di-i-propoxy-bis(ethyl acetoacetate)titanium, di-n-butoxy-bis(ethyl acetoacetate)titanium, di-sec-butoxy-bis(ethyl acetoacetate)titanium, di-t-butoxy-bis(ethyl acetoacetate)titanium, monoethoxy-tris(ethyl acetoacetate)titanium, mono-n-propoxy-tris(ethyl acetoacetate)titanium, mono-i-propoxy-tris(ethyl acetoacetate)titanium, mono-n-butoxy-tris(ethyl acetoacetate)titanium, mono-sec-butoxy-tris(ethyl acetoacetate)titanium, mono-t-butoxy-tris(ethyl acetoacetate)titanium, tetrakis(ethyl acetoacetate)titanium, mono(acetylacetonate)tris(ethyl acetoacetate)titanium, bis(acetylacetonate)bis(ethyl acetoacetate)titanium, and tris(acetylacetonate)mono(ethyl acetoacetate)titanium; zirconium chelate compounds such as triethoxy-mono(acetylacetonate)zirconium, tri-n-propoxy-mono(acetylacetonate)zirconium, tri-i-propoxy-mono(acetylacetonate)zirconium, tri-n-butoxy-mono(acetylacetonate)zirconium, tri-sec-butoxy-mono(acetylacetonate)zirconium, tri-t-butoxy-mono(acetylacetonate)zirconium, diethoxy-bis(acetylacetonate)zirconium, di-n-propoxy-bis(acetylacetonate)zirconium, di-i-propoxy-bis(acetylacetonate)zirconium, di-n-butoxy-bis(acetylacetonate)zirconium, di-sec-butoxy-bis(acetylacetonate)zirconium, di-t-butoxy-bis(acetylacetonate)zirconium, monoethoxy-tris(acetylacetonate)zirconium, mono-n-propoxy-tris(acetylacetonate)zirconium, mono-i-propoxy-tris(acetylacetonate)zirconium, mono-n-butoxy-tris(acetylacetonate)zirconium, mono-sec-butoxy-tris(acetylacetonate)zirconium, mono-t-butoxy-tris(acetylacetonate)zirconium, tetrakis(acetylacetonate)zirconium, triethoxy-mono(ethyl acetoacetate)zirconium, tri-n-propoxy-mono(ethyl acetoacetate)zirconium, tri-i-propoxy-mono(ethyl acetoacetate)zirconium, tri-n-butoxy-mono(ethyl acetoacetate)zirconium, tri-sec-butoxy-mono(ethyl acetoacetate)zirconium, tri-t-butoxy-mono(ethyl acetoacetate)zirconium, diethoxy-bis(ethyl acetoacetate)zirconium, di-n-propoxy-bis(ethyl acetoacetate)zirconium, di-i-propoxy-bis(ethyl acetoacetate)zirconium, di-n-butoxy-bis(ethyl acetoacetate)zirconium, di-sec-butoxy-bis(ethyl acetoacetate)zirconium, di-t-butoxy-bis(ethyl acetoacetate)zirconium, monoethoxy-tris(ethyl acetoacetate)zirconium, mono-n-propoxy-tris(ethyl acetoacetate)zirconium, mono-i-propoxy-tris(ethyl acetoacetate)zirconium, mono-n-butoxy-tris(ethyl acetoacetate)zirconium, mono-sec-butoxy-tris(ethyl acetoacetate)zirconium, mono-t-butoxy-tris(ethyl acetoacetate)zirconium, tetrakis(ethyl acetoacetate)zirconium, mono(acetylacetonate)tris(ethyl acetoacetate)zirconium, bis(acetylacetonate)bis(ethyl acetoacetate)zirconium, and tris(acetylacetonate)mono(ethyl acetoacetate)zirconium; and aluminum chelate compounds such as tris(acetylacetonate)aluminum and tris(ethyl acetoacetate)aluminum.

Examples of the organic acid as the hydrolysis catalyst include, but are not limited to, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartaric acid.

Examples of the inorganic acid as the hydrolysis catalyst include, but are not limited to, hydrochloric acid, nitric acid, sulfuric acid, hydrofluoric acid, and phosphoric acid.

Examples of the organic base as the hydrolysis catalyst include, but are not limited to, pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, trimethylphenylammonium hydroxide, benzyltrimethylammonium hydroxide, and benzyltriethylammonium hydroxide.

Examples of the inorganic base as the hydrolysis catalyst include, but are not limited to, ammonia, sodium hydroxide, potassium hydroxide, barium hydroxide, and calcium hydroxide.

Among these catalysts, a metal chelate compound, an organic acid, and an inorganic acid are preferred. These catalysts may be used singly or in combination of two or more kinds thereof.

In particular, nitric acid can be preferably used as a hydrolysis catalyst in the present invention. The use of nitric acid enables an improvement in the storage stability of a reaction solution after the hydrolysis and condensation, and particularly enables suppression of a change in the molecular weight of a hydrolysis condensate. It is known that the stability of the hydrolysis condensate contained in the reaction solution depends on the pH of the solution. As a result of intensive studies, it has been found that the pH of the reaction solution falls in a stable range by use of an appropriate amount of nitric acid.

As described above, nitric acid can also be used for preparation of a modified product of the hydrolysis condensate; for example, for capping of silanol groups with an alcohol. Thus, nitric acid is preferred from the viewpoint that it can contribute to the reactions of hydrolysis and condensation of the hydrolyzable silane, as well as the reaction of capping of the hydrolysis condensate with an alcohol.

When hydrolysis and condensation are performed, an organic solvent may be used as a solvent, and specific examples thereof include aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, and n-amylnaphthalene; monoalcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents such as ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchone; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxy triglycol, tetraethylene glycol di-n-butyl ether, propylene glycol monomethyl ether (1-methoxy-2-propanol), propylene glycol monoethyl ether (1-ethoxy-2-propanol), propylene glycol monopropyl ether, propylene glycol monobutyl ether, propylene glycol monomethyl ether acetate (1-methoxy-2-propanol monoacetate), dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethylene glycol diacetate, triethylene glycol methyl ether acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methyl-2-pyrrolidone; and sulfur-containing solvents such as dimethyl sulfide, diethyl sulfide, thiophene, tetrahydrothiophene, dimethyl sulfoxide, sulfolane, and 1,3-propane sultone, but are not limited thereto. These solvents can be used singly or in combination of two or more kinds thereof.

After completion of the hydrolysis and condensation reactions, the reaction solution is used as it is, or diluted or concentrated. The resultant reaction solution can be neutralized and treated with an ion exchange resin, and thus the hydrolysis catalyst, e.g. an acid or a base, used for the hydrolysis and condensation can be removed. In addition, before or after such treatment, alcohol and water as by-products, the hydrolysis catalyst used, and the like can be removed from the reaction solution by distillation under reduced pressure or the like.

The thus-prepared hydrolysis condensate is in the form of a polysiloxane varnish dissolved in an organic solvent, and may be used as is for preparation of a surface modifier. That is, the reaction solution may be used as is (or diluted) for preparation of the surface modifier. In this case, the hydrolysis catalyst used for the hydrolysis and condensation, by-products, and the like may remain in the reaction solution, so long as the effect of the present invention is not impaired. For example, nitric acid used as a hydrolysis catalyst or used for capping of silanol groups with an alcohol may remain in the polymer varnish solution in an amount of about 100 ppm to 5,000 ppm.

The resultant polysiloxane varnish may be subjected to solvent replacement, or may be appropriately diluted with a solvent. In a case where the storage stability of the resultant polysiloxane varnish is not poor, the organic solvent may be distilled off to achieve a film-forming component concentration of 100%. The film-forming component refers to a component resulted from the removal of a solvent component from all the components of the composition.

The organic solvent used for solvent replacement, dilution, or the like of the polysiloxane varnish may be identical to or different from the organic solvent used for the hydrolysis and condensation reactions of the hydrolyzable silane. The solvent for dilution is not particularly limited, and one kind or two or more kinds of solvents may be arbitrarily selected and used.

The content of the polysiloxane (A) in the surface modifier is not particularly limited; however, the content is preferably 0.01 mass% to 10 mass%, more preferably 0.05 mass% to 5 mass%, and particularly preferably 0.1 mass% to 3 mass%.

### <<<Solvent (B)>>>

The solvent (B) contained in the surface modifier can be used without particular limitation as long as it is a solvent capable of dissolving and mixing the polysiloxane (A) and, if necessary, other components contained in the surface modifier.

Examples of the solvent include an organic solvent or water.

Examples of the organic solvent include an alcohol, a carboxylic acid having a hydroxy group, a linear or cyclic alkyl ketone, a cyclic lactone, an alkylene glycol alkyl ether, and an alkylene glycol monoalkyl ether carboxylic acid ester (monocarboxylic acid ester of alkylene glycol monoalkyl ether and alkoxycarboxylic acid ester of alkylene glycol monoalkyl ether).

Examples of the alcohol include a monoalcohol-based solvent and a polyhydric alcohol-based solvent.

Examples of the monoalcohol-based solvent include methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol.

Examples of the polyhydric alcohol-based solvent include ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the carboxylic acid having a hydroxy group include ethyl lactate, propyl lactate, isopropyl lactate, butyl lactate, isobutyl lactate, ethyl hydroxyacetate, ethyl 2-hydroxy-2-methylpropionate, ethyl 2-hydroxypropionate, and methyl 2-hydroxy-3-methylbutyrate.

Examples of the linear or cyclic alkyl ketone include methyl ethyl ketone, cyclopentanone, and cyclohexanone.

Examples of the cyclic lactone include γ-butyrolactone.

Examples of the alkylene glycol alkyl ether include alkylene glycol monoalkyl ethers and alkylene glycol dialkyl ethers.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Examples of the alkylene glycol dialkyl ether include diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, and propylene glycol dibutyl ether.

Examples of the alkylene glycol monoalkyl ether carboxylic acid ester include monocarboxylic acid esters of alkylene glycol monoalkyl ethers and alkoxycarboxylic acid esters of alkylene glycol monoalkyl ethers.

Examples of the monocarboxylic acid ester of alkylene glycol monoalkyl ether include alkylene glycol monoalkyl ether acetate.

Examples of the alkylene glycol monoalkyl ether acetate include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, ethylene glycol monomethyl ether acetate, ethylene glycol monoethyl ether acetate, ethylene glycol monopropyl ether acetate, and ethylene glycol monobutyl ether acetate.

Examples of the alkoxycarboxylic acid ester of an alkylene glycol monoalkyl ether include 2-methoxyethyl methyl carbonate, 2-ethoxyethyl methyl carbonate, 2-ethoxyethyl ethyl carbonate, and 2-propoxyethyl methyl carbonate.

Specific examples of other solvents include toluene, xylene, ethyl ethoxyacetate, methyl 3-methoxypropionate, ethyl 3-methoxypropionate, ethyl 3-ethoxypropionate, methyl 3-ethoxypropionate, methyl pyruvate, ethyl pyruvate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, methyl 3-methoxy-2-methylpropionate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, methyl propyl ketone, methyl butyl ketone, 2-heptanone, 3-heptanone, 4-heptanone, N,N-dimethylformamide, N-methylacetamide, N,N-dimethylacetamide, N-methyl-2-pyrrolidone, and 4-methyl-2-pentanol.

These solvents can be used singly or in combination of two or more types thereof.

The surface modifier may contain water as a solvent. When water is contained as the solvent, the content thereof may be, for example, 30 mass% or less, preferably 20 mass% or less, and still more preferably 15 mass% or less relative to the total mass of the solvent contained in the surface modifier.

### <<<Curing catalyst (C)>>>

The surface modifier may be a composition containing no curing catalyst. Alternatively, the surface modifier preferably contains a curing catalyst.

The curing catalyst may be, for example, an ammonium salt, a phosphine compound, a phosphonium salt, a sulfonium salt, an iodonium salt, an oxonium salt. The following salts described as an example of the curing catalyst may be added in the form of a salt or may form a salt in the composition (one that is added as a separate compound at the time of addition and forms a salt in the system).

Examples of the ammonium salt include a quaternary ammonium salt having a structure represented by formula (D-1): 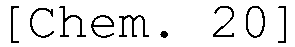 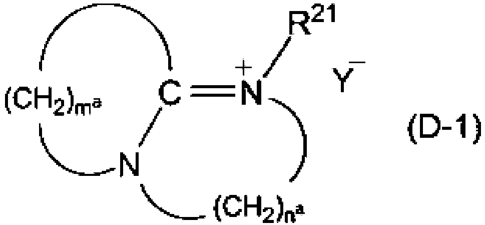
wherein m^{a} represents an integer of 2 to 11, n^{a} represents an integer of 2 to 3, R²¹ represents an alkyl group, an aryl group, or an aralkyl group, and Y⁻ represents an anion;
a quaternary ammonium salt having a structure represented by formula (D-2):
   [Chem. 21]

   R²²R²³R²⁴R²⁵N⁺Y⁻ (D-2)
wherein R²², R²³, R²⁴, and R²⁵ each independently represent an alkyl group, an aryl group, or an aralkyl group, Y⁻ represents an anion, and R²², R²³, R²⁴, and R²⁵ are each bonded to the nitrogen atom;
a quaternary ammonium salt having a structure represented by formula (D-3): 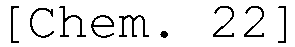 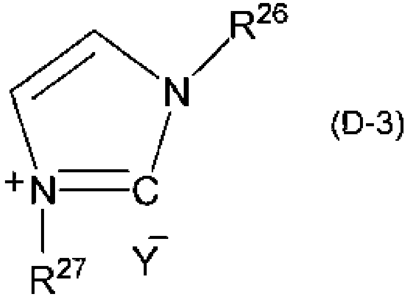
wherein R²⁶ and R²⁷ each independently represent an alkyl group, an aryl group, or an aralkyl group, and Y⁻ represents an anion;
a quaternary ammonium salt having a structure represented by formula (D-4): 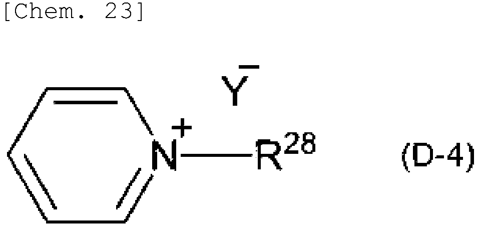
wherein R²⁸ represents an alkyl group, an aryl group, or an aralkyl group, and Y⁻ represents an anion;
a quaternary ammonium salt having a structure represented by formula (D-5): 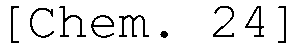 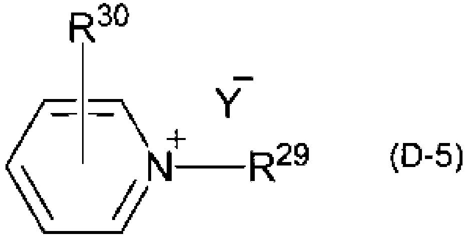
wherein R²⁹ and R³⁰ each independently represent an alkyl group, an aryl group, or an aralkyl group, and Y⁻ represents an anion; and
a tertiary ammonium salt having a structure represented by formula (D-6): 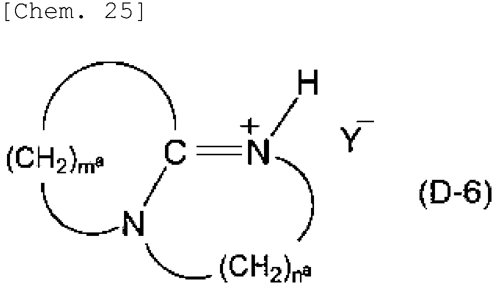
wherein m^{a} represents an integer of 2 to 11, n^{a} represents an integer of 2 to 3, and Y⁻ represents an anion.

Examples of the phosphonium salt include a quaternary phosphonium salt represented by formula (D-7):
[Chem. 26]

R³¹R³²R³³R³⁴P⁺Y⁻ (D-7)

wherein R³¹, R³², R³³, and R³⁴ each independently represent an alkyl group, an aryl group, or an aralkyl group, Y⁻ represents an anion, and R³¹, R³², R³³, and R³⁴ are each bonded to the phosphorus atom.

Examples of the sulfonium salt include a tertiary sulfonium salt represented by formula (D-8):
[Chem. 27]

R³⁵R³⁶R³⁷S⁺Y⁻ (D-8)

wherein R³⁵, R³⁶, and R³⁷ each independently represent an alkyl group, an aryl group, or an aralkyl group, Y⁻ represents an anion, and R³⁵, R³⁶, and R³⁷ are each bonded to the sulfur atom.

The compound of the formula (D-1) is a quaternary ammonium salt derived from an amine, where m^{a} represents an integer of 2 to 11, and n^{a} represents an integer of 2 to 3. R²¹ of the quaternary ammonium salt represents, for example, an alkyl group having 1 to 18 carbon atoms, preferably 2 to 10 carbon atoms, an aryl group having 6 to 18 carbon atoms, or an aralkyl group having 7 to 18 carbon atoms. Examples thereof include linear alkyl groups such as an ethyl group, a propyl group, and a butyl group; a benzyl group, a cyclohexyl group, a cyclohexylmethyl group, and a dicyclopentadienyl group. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻).

The compound of the formula (D-2) is a quaternary ammonium salt represented by R²²R²³R²⁴R²⁵N⁺Y⁻. R²², R²³, R²⁴, and R²⁵ of this quaternary ammonium salt are each, for example, an alkyl group having 1 to 18 carbon atoms such as an ethyl group, a propyl group, a butyl group, a cyclohexyl group, and a cyclohexylmethyl group, an aryl group having 6 to 18 carbon atoms such as a phenyl group, or an aralkyl group having 7 to 18 carbon atoms such as a benzyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The quaternary ammonium salt is commercially available, and examples of the quaternary ammonium salt include tetramethylammonium acetate, tetrabutylammonium acetate, triethylbenzylammonium chloride, triethylbenzylammonium bromide, trioctylmethylammonium chloride, tributylbenzylammonium chloride, and trimethylbenzylammonium chloride.

The compound of the formula (D-3) is a quaternary ammonium salt derived from 1-substituted imidazole. The number of carbon atoms of each of R²⁶ and R²⁷ is, for example, 1 to 18, and the total number of carbon atoms of R²⁶ and R²⁷ is preferably 7 or more. Examples of R²⁶ include alkyl groups, such as a methyl group, an ethyl group, and a propyl group, aryl groups, such as a phenyl group, and aralkyl groups, such as a benzyl group. Examples of R²⁷ include aralkyl groups, such as a benzyl group, and alkyl groups, such as an octyl group and an octadecyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between an imidazole compound (e.g. 1-methylimidazole or 1-benzylimidazole) and an aralkyl halide, an alkyl halide, or an aryl halide, such as benzyl bromide, methyl bromide, or benzene bromide.

The compound of the formula (D-4) is a quaternary ammonium salt derived from pyridine. R²⁸ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a butyl group, an octyl group, a benzyl group, and a lauryl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between pyridine and an alkyl halide or an aryl halide, such as lauryl chloride, benzyl chloride, benzyl bromide, methyl bromide, or octyl bromide. Examples of this compound include N-laurylpyridinium chloride and N-benzylpyridinium bromide.

The compound of the formula (D-5) is a quaternary ammonium salt derived from a substituted pyridine, such as picoline. R²⁹ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include a methyl group, an octyl group, a lauryl group, and a benzyl group. R³⁰ is, for example, an alkyl group having 1 to 18 carbon atoms, an aryl group having 6 to 18 carbon atoms, or an aralkyl group having 7 to 18 carbon atoms. For example, R³⁰ is a methyl group when the compound represented by the formula (D-5) is a quaternary ammonium derived from picoline. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between a substituted pyridine (e.g. picoline) and an alkyl halide or an aryl halide, such as methyl bromide, octyl bromide, lauryl chloride, benzyl chloride, or benzyl bromide. Examples of this compound include N-benzylpicolinium chloride, N-benzylpicolinium bromide, and N-laurylpicolinium chloride.

The compound of the formula (D-6) is a tertiary ammonium salt derived from an amine, where m^{a} represents an integer of 2 to 11, and n^{a} represents 2 or 3. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The compound may be produced through reaction between an amine and a weak acid, such as a carboxylic acid or phenol. Examples of the carboxylic acid include formic acid and acetic acid. When formic acid is used, the anion (Y⁻) is (HCOO⁻). When acetic acid is used, the anion (Y⁻) is (CH₃COO⁻). When phenol is used, the anion (Y⁻) is (C₆H₅O⁻).

The compound of the formula (D-7) is a quaternary phosphonium salt having a structure of R³¹R³²R³³R³⁴P⁺Y⁻. R³¹, R³², R³³, and R³⁴ are each, for example, an alkyl group having 1 to 18 carbon atoms, such as an ethyl group, a propyl group, a butyl group, or cyclohexylmethyl, an aryl group having 6 to 18 carbon atoms, such as a phenyl group, or an aralkyl group having 7 to 18 carbon atoms, such as a benzyl group. Three of four substituents of R³¹ to R³⁴ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). This compound is commercially available, and examples of the compound include tetraalkylphosphonium halides, such as tetra-n-butylphosphonium halide and tetra-n-propylphosphonium halide; trialkylbenzylphosphonium halides, such as triethylbenzylphosphonium halide; triphenylmonoalkylphosphonium halides, such as triphenylmethylphosphonium halide and triphenylethylphosphonium halide; triphenylbenzylphosphonium halide; tetraphenylphosphonium halide; tritolylmonoarylphosphonium halide; or tritolylmonoalkylphosphonium halide, where the halogen atom is a chlorine atom or a bromine atom. Particularly preferred are triphenylmonoalkylphosphonium halides, such as triphenylmethylphosphonium halide and triphenylethylphosphonium halide; triphenylmonoarylphosphonium halides, such as triphenylbenzylphosphonium halide; tritolylmonoarylphosphonium halides, such as tritolylmonophenylphosphonium halide; and tritolylmonoalkylphosphonium halides, such as tritolylmonomethylphosphonium halide, where the halogen atom is a chlorine atom or a bromine atom.

Examples of the phosphine compound include primary phosphines, such as methylphosphine, ethylphosphine, propylphosphine, isopropylphosphine, isobutylphosphine, and phenylphosphine; secondary phosphines, such as dimethylphosphine, diethylphosphine, diisopropylphosphine, diisoamylphosphine, and diphenylphosphine; and tertiary phosphines, such as trimethylphosphine, triethylphosphine, triphenylphosphine, methyldiphenylphosphine, and dimethylphenylphosphine.

The compound of the formula (D-8) is a tertiary sulfonium salt having a structure of R³⁵R³⁶R³⁷S⁺Y⁻. R³⁵, R³⁶, and R³⁷ are each, for example, an alkyl group having 1 to 18 carbon atoms, such as an ethyl group, a propyl group, a butyl group, or a cyclohexylmethyl, an aryl group having 6 to 18 carbon atoms, such as a phenyl group, or an aralkyl group having 7 to 18 carbon atoms, such as a benzyl group. Two of three substituents of R³⁵ to R³⁷ are each preferably an unsubstituted phenyl group or a substituted phenyl group. Examples thereof include a phenyl group or a tolyl group. The remaining one substituent is an alkyl group having 1 to 18 carbon atoms, an aryl group having 6 to 18 carbon atoms, or an aralkyl group having 7 to 18 carbon atoms. Further, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), alcoholate (-O⁻), maleate anion, and nitrate anion. This compound is commercially available, and examples of the compound include trialkylsulfonium halides, such as tri-n-butylsulfonium halide and tri-n-propylsulfonium halide; dialkylbenzylsulfonium halides, such as diethylbenzylsulfonium halide; diphenylmonoalkylsulfonium halides, such as diphenylmethylsulfonium halide and diphenylethylsulfonium halide; triphenylsulfonium halides, where, in all of the above halogenated compounds, the halogen atom is a chlorine atom or a bromine atom; trialkylsulfonium carboxylates, such as tri-n-butylsulfonium carboxylate and tri-n-propylsulfonium carboxylate; dialkylbenzylsulfonium carboxylates, such as diethylbenzylsulfonium carboxylate; diphenylmonoalkylsulfonium carboxylates, such as diphenylmethylsulfonium carboxylate and diphenylethylsulfonium carboxylate; and triphenylsulfonium carboxylate. Further, triphenylsulfonium halide and triphenylsulfonium carboxylate are preferably used.

In addition, a nitrogen-containing silane compound may be added as a curing catalyst. Examples of the nitrogen-containing silane compound include silane compounds containing an imidazole ring, such as N-(3-triethoxysilylpropyl)-4,5-dihydroimidazole.

The content of the curing catalyst in the surface modifier is preferably 0.01 to 30 parts by mass, more preferably 0.01 to 25 parts by mass, and still more preferably 0.01 to 20 parts by mass, relative to 100 parts by mass of the polysiloxane (A).

### <<<Acid>>>

The surface modifier preferably contains an acid.

The acid may be added during preparation of the surface modifier, and may be used as a hydrolysis catalyst or used for capping of silanol groups with an alcohol in the production of the polysiloxane (A) described above, and the acid remaining in the resultant polysiloxane varnish may be regarded as the acid.

Examples of the acid include an organic acid and an inorganic acid.

Examples of the organic acid include acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, sorbic acid, acrylic acid, methacrylic acid, trifluoromethanesulfonic acid, nonafluorobutanesulfonic acid, phenolsulfonic acid, 5-sulfosalicylic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartar.

Examples of the inorganic acid include hydrochloric acid, nitric acid, sulfuric acid, hydrofluoric acid, and phosphoric acid.

The amount of the acid (amount of residual acid) added may be, for example, 0.0001 mass% to 1 mass%, 0.001 mass% to 0.1 mass%, or 0.005 mass% to 0.05 mass% relative to the total mass of the surface modifier.

### <<<Amine and Hydroxide>>>

The surface modifier may contain at least one selected from an amine and a hydroxide.

Examples of the amine include ammonia; primary amines such as monomethanolamine, monoethanolamine, monopropanolamine, methylamine, ethylamine, propylamine, and butylamine; secondary amines such as dimethylamine, ethylmethylamine, and diethylamine; tertiary amines such as trimethylamine, triethylamine, tripropylamine, dimethylethylamine, methyldiisopropylamine, diisopropylethylamine, diethylethanolamine, and triethanolamine; amines such as ethylenediamine and tetramethylethylenediamine; and cyclic amines such as pyridine and morpholine.

Examples of the hydroxide include an inorganic alkali hydroxide and an organic alkali hydroxide.

Examples of the inorganic alkali hydroxide include sodium hydroxide and potassium hydroxide.

Examples of the organic alkali hydroxide include tetraalkylammonium hydroxide, triarylsulfonium hydroxide, and diaryliodonium hydroxide. Examples of the tetraalkylammonium hydroxide include tetramethylammonium hydroxide, tetraethylammonium hydroxide, and tetrabutylammonium hydroxide. Examples of the triarylsulfonium hydroxide include triphenylsulfonium hydroxide and tris(t-butylphenyl)sulfonium hydroxide. Examples of the diaryliodonium hydroxide include diphenyliodonium hydroxide and bis(t-butylphenyl)iodonium hydroxide.

The contents of the amine and the hydroxide in the surface modifier are not particularly limited, but can be preferably 0.05 to 20 parts by mass, more preferably 0.1 to 15 parts by mass, and still more preferably 0.5 to 10 parts by mass relative to 100 parts by mass of the polysiloxane (A).

### <<<Other Additives>>>

Various additives can be added to the surface modifier depending on the intended use of the composition.

Examples of the additives include known additives incorporated in materials (compositions) for forming various films (e.g. resist underlayer film, anti-reflective coating, and pattern reversing film) that can be used in the production of a semiconductor device, such as a crosslinking agent, a crosslinking catalyst, a stabilizer (e.g. an organic acid, water, or an alcohol), an organic polymer, an acid generator, a surfactant (e.g. a nonionic surfactant, an anionic surfactant, a cationic surfactant, a silicon-based surfactant, a fluorine-based surfactant, or an UV-curable surfactant), a pH adjuster, a metal oxide, a rheology controlling agent, and an adhesion aid.

Hereinafter, various additives will be exemplified, but the additives are not limited thereto.

### -Stabilizer-

The stabilizer may be added for the purpose of stabilizing the hydrolysis condensate of the hydrolyzable silane mixture, or the like. Specific examples of the stabilizer include an organic acid, water, an alcohol, or a combination thereof.

Examples of the organic acid include oxalic acid, malonic acid, methylmalonic acid, succinic acid, maleic acid, malic acid, tartaric acid, phthalic acid, citric acid, glutaric acid, lactic acid, and salicylic acid. Among these organic acids, oxalic acid and maleic acid are preferred. When the organic acid is added, the amount of the organic acid added is 0.1 to 5.0 mass% relative to the mass of the hydrolysis condensate of the hydrolyzable silane mixture. These organic acids may also serve as pH adjusters.

As the water, pure water, ultrapure water, ion exchanged water, or the like may be used. When pure water, ultrapure water, or ion exchanged water is used, the amount of the water added can be 0.1 to 20 parts by mass relative to 100 parts by mass of the surface modifier.

The alcohol is preferably an alcohol that is easily volatilized by heating after the application, and examples of the alcohol include methanol, ethanol, propanol, i-propanol, and butanol. When an alcohol is added, the amount of the alcohol added may be 0.1 to 20 parts by mass relative to 100 parts by mass of the surface modifier.

### -Organic Polymer-

Addition of an organic polymer to the surface modifier enables adjustment of the dry etching rate (amount of reduction in film thickness per unit time), attenuation coefficient, refractive index, and the like of the surface-modified layer formed from the surface modifier. The organic polymer is not particularly limited, and is appropriately selected from various organic polymers (polycondensation polymer and addition polymerization polymer) depending on the purpose of addition thereof.

Specific examples of the organic polymer include addition polymerization polymers and polycondensation polymers, such as polyester, polystyrene, polyimide, acrylic polymer, methacrylic polymer, polyvinyl ether, phenol novolac, naphthol novolac, polyether, polyamide, and polycarbonate.

In the present invention, an organic polymer containing an aromatic ring or a heteroaromatic ring such as a benzene ring, a naphthalene ring, an anthracene ring, a triazine ring, a quinoline ring, or a quinoxaline ring, which functions as a light-absorbing moiety, can also be preferably used when such a function is required. Specific examples of such an organic polymer include, but are not limited to, addition polymerization polymers containing, as structural units, addition polymerizable monomers, such as benzyl acrylate, benzyl methacrylate, phenyl acrylate, naphthyl acrylate, anthryl methacrylate, anthrylmethyl methacrylate, styrene, hydroxystyrene, benzyl vinyl ether, and N-phenylmaleimide, and polycondensation polymers, such as phenol novolac and naphthol novolac.

When an addition polymerization polymer is used as an organic polymer, the polymer may be either a homopolymer or a copolymer.

An addition polymerizable monomer is used for the production of the addition polymerization polymer. Specific examples of the addition polymerizable monomer include, but are not limited to, acrylic acid, methacrylic acid, an acrylate ester compound, a methacrylate ester compound, an acrylamide compound, a methacrylamide compound, a vinyl compound, a styrene compound, a maleimide compound, maleic anhydride, and acrylonitrile.

Specific examples of the acrylate ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2-hydroxyethyl acrylate, 3-chloro-2-hydroxypropyl acrylate, 2-hydroxypropyl acrylate, 2,2,2-trifluoroethyl acrylate, 2,2,2-trichloroethyl acrylate, 2-bromoethyl acrylate, 4-hydroxybutyl acrylate, 2-methoxyethyl acrylate, tetrahydrofurfuryl acrylate, 2-methyl-2-adamantyl acrylate, 5-acryloyloxy-6-hydroxynorbornene-2-carboxylic-6-lactone, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2-hydroxyethyl methacrylate, 2-hydroxypropyl methacrylate, 2,2,2-trifluoroethyl methacrylate, 2,2,2-trichloroethyl methacrylate, 2-bromoethyl methacrylate, 4-hydroxybutyl methacrylate, 2-methoxyethyl methacrylate, tetrahydrofurfuryl methacrylate, 2-methyl-2-adamantyl methacrylate, 5-methacryloyloxy-6-hydroxynorbornene-2-carboxylic-6-lactone, 3-methacryloxypropyltriethoxysilane, glycidyl methacrylate, 2-phenylethyl methacrylate, hydroxyphenyl methacrylate, and bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the vinyl compound include, but are not limited to, vinyl alcohol, 2-hydroxyethyl vinyl ether, methyl vinyl ether, ethyl vinyl ether, benzyl vinyl ether, vinyl acetate, vinyltrimethoxysilane, 2-chloroethyl vinyl ether, 2-methoxyethyl vinyl ether, vinylnaphthalene, and vinylanthracene.

Specific examples of the styrene compound include, but are not limited to, styrene, hydroxystyrene, chlorostyrene, bromostyrene, methoxystyrene, cyanostyrene, and acetylstyrene.

Examples of the maleimide compound include, but are not limited to, maleimide, N-methylmaleimide, N-phenylmaleimide, N-cyclohexylmaleimide, N-benzylmaleimide, and N-hydroxyethylmaleimide.

When a polycondensation polymer is used as the organic polymer, the polymer is, for example, a polycondensation polymer composed of a glycol compound and a dicarboxylic acid compound. Examples of the glycol compound include diethylene glycol, hexamethylene glycol, and butylene glycol. Examples of the dicarboxylic acid compound include succinic acid, adipic acid, terephthalic acid, and maleic anhydride. Further, examples of the polymer include, but are not limited to, polyesters, polyamides, and polyimides, such as polypyromellitimide, poly(p-phenyleneterephthalamide), polybutylene terephthalate, and polyethylene terephthalate.

When the organic polymer contains a hydroxy group, the hydroxy group may be crosslinked with a hydrolysis condensate, or the like.

The organic polymer may ordinarily have a weight-average molecular weight of 1,000 to 1,000,000. From the viewpoint of sufficiently achieving the effect of the polymer function and preventing the precipitation of the polymer in the composition, the weight-average molecular weight of the organic polymer to be added may be, for example, 3,000 to 300,000, 5,000 to 300,000, or 10,000 to 200,000.

Such an organic polymer may be used singly or in combination of two or more kinds thereof.

When the surface modifier contains an organic polymer in addition to the polysiloxane (A), the content of the organic polymer cannot be univocally determined, since the content should be appropriately determined in consideration of the function of the organic polymer or the like. Ordinarily, the content may be 1 to 200 mass% relative to the polysiloxane (A). From the viewpoint of preventing the precipitation of the organic polymer in the composition and the like, the content may be, for example, 100 mass% or less, preferably 50 mass% or less, and more preferably 30 mass% or less. From the viewpoint of sufficiently achieving the effect of the polymer and the like, the content may be, for example, 5 mass% or more, preferably 10 mass% or more, and more preferably 30 mass% or more.

### -Acid Generator-

Examples of the acid generator include a thermal acid generator and a photoacid generator, and a photoacid generator may be preferably used.

Examples of the photoacid generator include, but are not limited to, onium salt compounds such as a sulfonium salt, a phosphonium salt, an ammonium salt, an iodonium salt, and an oxonium salt, a sulfonimide compound, and a disulfonyl diazomethane compound. The photoacid generator may also function as a curing catalyst depending on the type thereof, for example, a nitrate salt, a carboxylate salt such as maleate, or a hydrochloride salt of an onium salt compound described below.

Examples of the thermal acid generator include, but are not limited to, tetramethylammonium nitrate.

Specific examples of the onium salt compound include, but are not limited to, iodonium salt compounds, such as diphenyliodonium hexafluorophosphate, diphenyliodonium trifluoromethanesulfonate, diphenyliodonium nonafluoro normal butanesulfonate, diphenyliodonium perfluoro normal octanesulfonate, diphenyliodonium camphorsulfonate, bis(4-t-butylphenyl)iodonium camphorsulfonate, and bis(4-t-butylphenyl)iodonium trifluoromethanesulfonate; and sulfonium salt compounds, such as triphenylsulfonium hexafluoroantimonate, triphenylsulfonium nonafluoro normal butanesulfonate, triphenylsulfonium camphorsulfonate, triphenylsulfonium trifluoromethanesulfonate, triphenylsulfonium nitrate, triphenylsulfonium trifluoroacetate, triphenylsulfonium maleate, and triphenylsulfonium chloride.

Specific examples of the sulfonimide compound include, but are not limited to, N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

When the surface modifier contains an acid generator, the content of the acid generator cannot be univocally determined, since the amount should be appropriately determined in consideration of the type of the acid generator and the like. Ordinarily, the content of the acid generator is 0.01 to 5 mass% relative to the mass of the polysiloxane (A). From the viewpoint of preventing the precipitation of the acid generator in the composition and the like, the content is preferably 3 mass% or less, more preferably 1 mass% or less. From the viewpoint of sufficiently achieving the effect of the acid generator and the like, the content is preferably 0.1 mass% or more, more preferably 0.5 mass% or more.

The acid generators may be used singly or in combination of two or more kinds thereof. A photoacid generator and a thermal acid generator may be used in combination.

### -Surfactant-

When the surface modifier is applied to a substrate, a surfactant is effective in prevention of formation of pinholes, striations, and the like. Examples of the surfactant include a nonionic surfactant, an anionic surfactant, a cationic surfactant, a silicon-based surfactant, a fluorine-based surfactant, and a UV-curable surfactant. Specific examples of the surfactant include, but are not limited to, nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylaryl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as trade names EFTOP (registered trademark) EF301, EF303, and EF352 (manufactured by Mitsubishi Materials Electronic Chemicals Co., Ltd. (former Tohkem Products Corporation)), trade names MEGAFACE (registered trademark) F171, F173, R-08, R-30, R-30N, and R-40LM (manufactured by DIC Corporation), Fluorad FC430 and FC431 (manufactured by 3M Japan Limited), trade name AsahiGuard (registered trademark) AG710 (manufactured by AGC Inc.), and trade names SURFLON (registered trademark) S-382, SC101, SC102, SC103, SC104, SC105, and SC106 (manufactured by AGC Seimi Chemical Co., Ltd.); and Organosiloxane Polymer KP341 (manufactured by Shin-Etsu Chemical Co., Ltd.).

The surfactants may be used singly or in combination of two or more kinds thereof.

When the surface modifier contains a surfactant, the content of the surfactant is ordinarily 0.0001 to 5 mass%, preferably 0.001 to 4 mass%, and more preferably 0.01 to 3 mass% relative to the mass of the polysiloxane (A).

### -Rheology Controlling Agent-

The rheology controlling agent is added mainly for the purpose of improving the fluidity of the surface modifier, particularly in a baking process, improving the uniformity of the film thickness of a film to be formed, and/or improving the fillability of the composition into holes. Specific examples of the rheology controlling agent include phthalic acid derivatives, such as dimethyl phthalate, diethyl phthalate, di-i-butyl phthalate, dihexyl phthalate, and butyl-i-decyl phthalate; adipic acid derivatives, such as di-normal butyl adipate, di-i-butyl adipate, di-i-octyl adipate, and octyl decyl adipate; maleic acid derivatives, such as di-normal butyl maleate, diethyl maleate, and dinonyl maleate; oleic acid derivatives, such as methyl oleate, butyl oleate, and tetrahydrofurfuryl oleate; and stearic acid derivatives, such as normal butyl stearate and glyceryl stearate.

When such a rheology controlling agent is used, the amount of the rheology controlling agent added is ordinarily less than 30 mass% relative to all film-forming components of the surface modifier.

### -Adhesion Aid-

The adhesion aid is added for the purpose of mainly improving the adhesion between a substrate or a resist and a film (surface-modified layer) formed from the surface modifier, in particular, suppressing or preventing the peeling of the resist during development. Specific examples of the adhesion aid include chlorosilanes, such as trimethylchlorosilane, dimethylvinylchlorosilane, methyldiphenylchlorosilane, and chloromethyldimethylchlorosilane; alkoxysilanes, such as trimethylmethoxysilane, dimethyldiethoxysilane, methyldimethoxysilane, and dimethylvinylethoxysilane; silazanes, such as hexamethyldisilazane, N,N'-bis(trimethylsilyl)urea, dimethyltrimethylsilylamine, and trimethylsilyl imidazole; other silanes, such as γ-chloropropyltrimethoxysilane, γ-aminopropyltriethoxysilane, and γ-glycidoxypropyltrimethoxysilane; heterocyclic compounds, such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, mercaptopyrimidine; and urea or thiourea compounds, such as 1,1-dimethylurea and 1,3-dimethylurea.

When such an adhesion aid is used, the amount of the adhesion aid added is ordinarily less than 5 mass%, preferably less than 2 mass%, relative to the film-forming components of the surface modifier.

### -pH Adjuster-

In addition, the pH adjuster may be an acid having one or two or more carboxylic acid groups, for example, an organic acid described above in -Stabilizer-. When a pH adjuster is used, the amount of the pH adjuster added may be 0.01 to 20 parts by mass, 0.01 to 10 parts by mass, or 0.01 to 5 parts by mass relative to 100 parts by mass of the polysiloxane (A).

### -Metal Oxide-

Examples of the metal oxide that may be added to the surface modifier include, but are not limited to, oxides of a combination of one or more selected from among metals, such as tin (Sn), titanium (Ti), aluminum (Al), zirconium (Zr), zinc (Zn), niobium (Nb), tantalum (Ta), and W (tungsten), and semimetals, such as boron (B), silicon (Si), germanium (Ge), arsenic (As), antimony (Sb), and tellurium (Te).

The concentration of the film-forming component in the surface modifier may be, for example, 0.01 to 50 mass%, 0.01 to 30 mass%, 0.01 to 25 mass%, or 0.01 to 20.0 mass% relative to the total mass of the composition.

The content of the polysiloxane (A) in the film-forming component is ordinarily 20 mass% to 100 mass%. From the viewpoint of achieving the effects of the present invention at high reproducibility or the like, the lower limit of the content of the polysiloxane (A) is preferably 50 mass%, more preferably 60 mass%, still more preferably 70 mass%, and yet still more preferably 80 mass%. The upper limit of the content is preferably 99 mass%. The balance may be an additive described above.

Further, the surface modifier preferably has a pH of 1 to 5, more preferably a pH of 2 to 4.

The surface modifier can be produced by mixing the polysiloxane (A), the solvent (B), and if other components are contained as desired, the other components. At this time, a solution containing the polysiloxane (A) may be prepared in advance, and this solution may be mixed with the solvent (B) and other components.

During preparation of the surface modifier, the components may be appropriately heated so long as the components are not decomposed or denatured.

During the production of the surface modifier, or after all the components have been mixed, filtration may be performed using a submicrometer-order filter or the like. Although the material type of the filter used at this time is not limited, for example, a polyethylene filter, a nylon filter, a fluororesin filter, a polyimide filter, or the like can be used.

### <Second step>

The second step is a step of bringing the surface-modified layer precursor into contact with a thinning liquid (X) to thin the surface-modified layer precursor and to form a surface-modified layer having a film thickness of 5 nm or less.

In the second step, the method of bringing the surface-modified layer precursor into contact with the thinning liquid (X) is not particularly limited. Spin coating is preferred from the viewpoint that the thickness can be uniformly thinned and the degree of thinning can be easily controlled with high accuracy. That is, the second step is preferably a step of spin-coating the surface-modified layer precursor with a thinning liquid (X) to thin the surface-modified layer precursor and to form a surface-modified layer having a film thickness of 5 nm or less.

The conditions for spin-coating are not particularly limited, and include, for example, an application treatment of applying a thinning liquid (X) to the surface-modified layer precursor of the semiconductor substrate on which the surface-modified layer precursor is formed, and a rotation treatment of rotating the semiconductor substrate.

In the application treatment, for example, when the thinning liquid (X) is applied to the surface-modified layer precursor, the semiconductor substrate is not rotated or rotated at a low speed (e.g. 1000 rpm or less). In the application treatment, the thinning liquid (X) is brought into contact with the surface-modified layer precursor, and thus the components in the surface-modified layer precursor are transferred to the thinning liquid (X).

In the rotation treatment, for example, the semiconductor substrate is rotated at a high speed (e.g. more than 1,000 rpm and 5,000 rpm or less), and the thinning liquid (X) is removed from the semiconductor substrate with the surface-modified layer precursor formed.

As a result of this process, the surface-modified layer precursor is thinned to the extent that the components in the surface-modified layer precursor are transferred to the thinning liquid (X). Consequently, a surface-modified layer having a film thickness of 5 nm or less is formed.

The time required for the application treatment is, for example, 10 seconds to 2 minutes.

The time required for the rotation treatment is, for example, 5 seconds to 1 minute.

At the time of rotation, for example, an axis orthogonal to the surface of the semiconductor substrate is set as a rotation axis.

In the second step, it is preferable that the thickness of the surface-modification-layer precursor be reduced by 0.5 nm to 10 nm, and more preferably by 1 nm to 5 nm.

### <<Thinning liquid (X)>>

The thinning liquid (X) is not particularly limited as long as it is a liquid in which the surface-modified layer precursor is brought into contact with the thinning liquid (X) to thin the surface-modified layer precursor, and examples thereof include an organic solvent, water, an acidic solution, and an alkaline aqueous solution. Alternatively, a thinner used in a reducing resist consumption (RRC) step or an edge bead removing (EBR) step can be used. These materials can be used singly or in combination of two or more kinds thereof.

Examples of the organic solvent include alcohols, alkylene glycol alkyl ethers, and alkylene glycol monoalkyl ether carboxylic acid esters.

Examples of the alcohol include a monoalcohol-based solvent and a polyhydric alcohol-based solvent.

Examples of the monoalcohol-based solvent include methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol.

Examples of the polyhydric alcohol-based solvent include ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the alkylene glycol alkyl ether include alkylene glycol monoalkyl ethers and alkylene glycol dialkyl ethers.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Examples of the alkylene glycol dialkyl ether include diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, and propylene glycol dibutyl ether.

Examples of the alkylene glycol monoalkyl ether carboxylic acid ester include alkylene glycol monoalkyl ether acetate.

Examples of the alkylene glycol monoalkyl ether acetate include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, ethylene glycol monomethyl ether acetate, ethylene glycol monoethyl ether acetate, ethylene glycol monopropyl ether acetate, and ethylene glycol monobutyl ether acetate.

Specific examples of other organic solvents include toluene, xylene, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxyisobutyrate, methyl 3-hydroxyisobutyrate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, methyl propyl ketone, methyl butyl ketone, 2-heptanone, 3-heptanone, 4-heptanone, N,N-dimethylformamide, N-methylacetamide, N,N-dimethylacetamide, N-methyl-2-pyrrolidone, and 4-methyl-2-pentanol.

Examples of the acidic solution include an inorganic acid aqueous solution, an organic acid aqueous solution, and an organic acid solution. Examples of the inorganic acid aqueous solution include a hydrochloric acid aqueous solution, a nitric acid aqueous solution, a phosphoric acid aqueous solution, a sulfuric acid aqueous solution, and a perchloric acid aqueous solution. Examples of the organic acid aqueous solution include an acetic acid aqueous solution, a trifluoroacetic acid aqueous solution, a camphorsulfonic acid aqueous solution, a p-toluenesulfonic acid aqueous solution, and a trifluoromethanesulfonic acid aqueous solution. Examples of the organic acid solution include a solution prepared by replacing water in the organic acid aqueous solution with an organic solvent. Examples of the organic solvent include alkylene glycol alkyl ether and alkylene glycol monoalkyl ether carboxylic acid ester.

Examples of the alkaline aqueous solution include developers used in a lithography process.

Examples of the alkaline aqueous solution include an inorganic alkaline aqueous solution and an organic alkaline aqueous solution. Examples of the inorganic alkaline aqueous solution include a potassium hydroxide aqueous solution, a sodium hydroxide aqueous solution, a sodium carbonate aqueous solution, a potassium carbonate aqueous solution, a sodium hydrogen carbonate aqueous solution, a potassium hydrogen carbonate aqueous solution, a sodium phosphate aqueous solution, and a potassium phosphate aqueous solution. Examples of the organic alkaline aqueous solution include a tetramethylammonium hydroxide aqueous solution, a tetraethylammonium hydroxide aqueous solution, a tetrabutylammonium hydroxide aqueous solution, a monoethanolamine aqueous solution, a diethanolamine aqueous solution, and a triethanolamine aqueous solution.

The concentration of the alkali in the alkaline aqueous solution is not particularly limited.

The reducing resist consumption (RRC) step is a step for reducing the amount of photoresist used, and is a process for treating the surface of a substrate with a thinner before applying the photoresist to uniformly apply a small amount of photoresist to the entire surface of the substrate.

The edge bead removing (EBR) step is a step for removing residues of unnecessary photoresist applied to the end portion or the rear surface portion of the substrate in the application process and other contaminants.

Examples of the thinner used in the RRC step and the EBR step include propylene glycol monomethyl ether, propylene glycol monomethyl ether acetate, propylene glycol monoethyl ether, cyclohexanone, ethyl lactate, γ-butyrolactone, ethyl 3-ethoxypropionate, methyl hydroxyisobutyrate, and mixtures thereof.

In an embodiment of the present invention, in the laminate, an organic underlayer film may be provided between the semiconductor substrate and the surface-modified layer.

The organic underlayer film used here is not particularly limited, and may be arbitrarily selected from organic underlayer films commonly used in the lithography process.

In one aspect, the organic underlayer film is formed on the substrate, and the surface-modified layer is formed on the organic underlayer film, followed by formation of a resist film as described below on the surface-modified layer. This can narrow the pattern width of a resist film. Thus, even when the resist film is formed thinly for preventing pattern collapse, the substrate can be processed through selection of an appropriate etching gas described below. For example, the resist underlayer film can be processed by using, as the etching gas, a fluorine-containing gas having a sufficiently fast etching rate for the resist film,
the organic underlayer film can be processed by using, as the etching gas, an oxygen-containing gas having a sufficiently fast etching rate for the resist underlayer film, and the substrate can be processed by using, as the etching gas, a fluorine-containing gas having a sufficiently fast etching rate for the organic underlayer film.

The substrate and application method usable in this process include those described above.

### (Method for Producing Semiconductor Element)

The method for producing a semiconductor element of the present invention includes: a step of forming a resist film on the laminate formed by the method for producing a laminate of the present invention; and a step of exposing and developing the resist film to form a resist pattern.

For example, a layer (resist film) of a photoresist material is formed on a surface-modified layer. The resist film can be formed by a well-known method. Specifically, the resist film can be formed by applying a coating-type resist material (e.g. a composition for forming a resist film) onto the surface-modified layer, and baking the resist material.

The resist film has a film thickness of, for example, 10 nm to 10,000 nm, or 100 nm to 2,000 nm, or 200 nm to 1,000 nm, or 30 nm to 200 nm.

The photoresist material used for the resist film formed on the surface-modified layer is not particularly limited as long as it is sensitive to light used for exposure (e.g. a KrF excimer laser or an ArF excimer laser), and both a negative photoresist material and a positive photoresist material can be used. Examples of the photoresist include a positive photoresist material formed of a novolac resin and 1,2-naphthoquinone diazide sulfonic acid ester; a chemically amplified photoresist material formed of a binder having a group that is decomposed by an acid to increase an alkali dissolution rate and a photoacid generator; a chemically amplified photoresist material formed of a low molecular weight compound that is decomposed by an acid to increase an alkali dissolution rate of the photoresist material, an alkali-soluble binder, and a photoacid generator; a chemically amplified photoresist material formed of a binder having a group that is decomposed by an acid to increase an alkali dissolution rate, a low molecular weight compound having a group that is decomposed by an acid to increase an alkali dissolution rate of the photoresist material, and photoacid generator.

Specific examples of commercially available products thereof include, but are not limited to, APEX-E (trade name, manufactured by Shipley Company L.L.C), PAR710 (trade name, manufactured by Sumitomo Chemical Co., Ltd.), AR2772JN (trade name, manufactured by JSR Corporation), and SEPR430 (trade name, manufactured by Shin-Etsu Chemical Co., Ltd.). Further, examples of the photoresist include a fluorine atom-containing polymer-based photoresist material as described in Proc. SPIE, Vol. 3999, 330-334 (2000), Proc. SPIE, Vol. 3999, 357-364 (2000), or Proc. SPIE, Vol. 3999, 365-374 (2000).

As the resist film formed on the surface-modified layer, a resist film for electron beam lithography (also referred to as an electron beam resist film) or a resist film for EUV lithography (also referred to as an EUV resist film) can be used instead of the photoresist film.

As the electron beam resist material for forming the electron beam resist film, both a negative type material and a positive type material can be used. Specific examples of the negative type material and the positive type material include: a chemically amplified resist material containing an acid generator and a binder having a group that is decomposed by an acid to change the alkali dissolution rate; a chemically amplified resist material containing an alkali-soluble binder, an acid generator, and a low molecular weight compound that is decomposed by an acid to change the alkali dissolution rate of the resist material; a chemically amplified resist material containing an acid generator, a binder having a group that is decomposed by an acid to change the alkali dissolution rate, and a low molecular weight compound that is decomposed by an acid to change the alkali dissolution rate of the resist material; a non-chemically amplified resist material containing a binder having a group that is decomposed by an electron beam to change the alkali dissolution rate; and a non-chemically amplified resist material containing a binder having a moiety that is cleaved by an electron beam to change the alkali dissolution rate. Even when these electron beam resist materials are used, a resist film pattern can be formed similarly to a case in which a photoresist material is used with an electron beam being used as an irradiation source.

As the EUV resist material for forming the EUV resist film, a methacrylate resin-based resist material, a polyhydroxystyrene resin-based resist material, and a methacrylate-polyhydroxystyrene hybrid resin-based resist material can be used.

The resist film may be a metal-containing resist film.

The metal-containing resist film is not particularly limited, and preferably has at least one element of Si, Ge, Sn, Ti, Zr, Hf, Al, and Co.

The metal-containing resist film is formed of, for example, a metal-containing resist.

The metal-containing resist is also called a metal oxide resist (MOR), and typical examples thereof include a tin oxide-based resist.

The material of the metal oxide resist is, for example, a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in Patent Literatures listed in paragraph[0011] of JP 2019-532489 W. Examples of the Patent Literature include US 9,176,377 B2, US 2013/0224652 A1, US 9,310,684 B2, US 2016/0116839 A1, and US 15/291738 A.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The method for forming the metal-containing resist film from the metal-containing resist is not particularly limited, and examples thereof include a method in which a coating-type resist material (metal-containing resist film-forming composition) as the metal-containing resist is applied and baked.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Subsequently, light exposure is performed on the resist film formed above the surface-modified layer through a predetermined mask (rectyl). The light exposure may be performed using a KrF excimer laser (wavelength: 248 nm), an ArF excimer laser (wavelength: 193 nm), an F₂ excimer laser (wavelength: 157 nm), EUV (wavelength: 13.5 nm), electron beams, or the like.

After the light exposure, post exposure bake may be performed as necessary. The post exposure bake is performed under appropriately selected conditions: a heating temperature of 70°C to 150°C and a heating time of 0.3 minutes to 10 minutes.

Next, development is performed with a developer (e.g. an alkaline developer). When, for example, a positive photoresist film is used, an exposed portion of the photoresist film is removed, and thus a pattern of the photoresist film is formed.

Examples of the developer (alkaline developer) include alkaline aqueous solutions (alkaline developers) such as: aqueous solutions of alkali metal hydroxides such as potassium hydroxide and sodium hydroxide; aqueous solutions of quaternary ammonium hydroxides such as tetramethylammonium hydroxide, tetraethylammonium hydroxide, and choline; and aqueous amine solutions such as ethanolamine, propylamine, and ethylenediamine. Furthermore, a surfactant or the like may be added to these developers. Development conditions are appropriately selected from a temperature of 5 to 50°C, and a time of 10 seconds to 600 seconds.

In the present invention, an organic solvent can be used as a developer. Development is performed with a developer (solvent) after light exposure. When, for example, a negative photoresist film is used, an unexposed portion of the photoresist film is removed, and thus a pattern of the photoresist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Furthermore, a surfactant or the like may be added to these developers. Development conditions are appropriately selected from a temperature of 5°C to 50°C, and a time of 10 seconds to 600 seconds.

For example, the surface-modified layer is removed using the pattern of the resist film (upper layer) thus formed as a protective film, and then the substrate is processed using the patterned resist film and the patterned surface-modified layer as protective films.

The surface-modified layer is removed (patterned) through dry etching by using the patterned resist film (upper layer) as a protective film. The dry etching can be performed using any of gases, such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane.

The dry etching of the surface-modified layer is preferably performed using a halogen-containing gas. The resist film (photoresist film) made of an organic material is basically less likely to be removed by dry etching with a halogen-containing gas. In contrast, the surface-modified layer containing numerous silicon atoms is quickly removed by a halogen-containing gas. Accordingly, a reduction in the film thickness of the photoresist film associated with the dry etching of the surface-modified layer can be suppressed. As a result, the photoresist film can be used in the form of thin film. Thus, the dry etching of the surface-modified layer is preferably performed using a fluorine-containing gas. Examples of the fluorine-containing gas include, but are not limited to, tetrafluoromethane (CF₄), perfluorocyclobutane (C₄F₈), perfluoropropane (C₃F₈), trifluoromethane, and difluoromethane (CH₂F₂).

Thereafter, the patterned surface-modified layer is used as a protective film to process (pattern) the (semiconductor) substrate. The (semiconductor) substrate is preferably processed (patterned) by dry etching with a fluorine-containing gas.

Examples of the fluorine-containing gas include tetrafluoromethane (CF₄), perfluorocyclobutane (C₄F₈), perfluoropropane (C₃F₈), trifluoromethane, and difluoromethane (CH₂F₂).

After processing (patterning) of the substrate, the surface-modified layer may be removed. The surface-modified layer may be removed by dry etching or wet etching.

The dry etching of the surface-modified layer is preferably performed with a fluorine-containing gas as described in the patterning. Examples of the fluorine-containing gas include, but are not limited to, tetrafluoromethane (CF₄), perfluorocyclobutane (C₄F₈), perfluoropropane (C₃F₈), trifluoromethane, and difluoromethane (CH₂F₂).

Examples of the chemical used for wet etching of the surface-modified layer include alkaline solutions, such as dilute hydrofluoric acid (hydrofluoric acid), buffered hydrofluoric acid (mixed solution of HF and NH₄F), an aqueous solution containing hydrochloric acid and hydrogen peroxide (SC-2 chemical), an aqueous solution containing sulfuric acid and hydrogen peroxide (SPM chemical), an aqueous solution containing hydrofluoric acid and hydrogen peroxide (FPM chemical), and an aqueous solution containing ammonia and hydrogen peroxide (SC-1 chemical). Further, examples of the alkaline solution include an aqueous solution containing 1 to 99 mass% of ammonia, tetramethylammonium hydroxide (TMAH), tetraethylammonium hydroxide, tetrapropylammonium hydroxide, tetrabutylammonium hydroxide, choline hydroxide, benzyltrimethylammonium hydroxide, benzyltriethylammonium hydroxide, DBU (diazabicycloundecene), DBN (diazabicyclononene), hydroxylamine, 1-butyl-1-methylpyrrolidinium hydroxide, 1-propyl-1-methylpyrrolidinium hydroxide, 1-butyl-1-methylpiperidinium hydroxide, 1-propyl-1-methylpiperidinium hydroxide, mepiquat hydroxide, trimethylsulfonium hydroxide, a hydrazine compound, an ethylenediamine compound, or guanidine, in addition to the ammonia-hydrogen peroxide mixture prepared by mixing ammonia, hydrogen peroxide water, and water described above (SC-1 chemical). These chemicals may be used in the form of mixture.

### Examples

Hereinafter, the present invention will be described more specifically with reference to synthesis examples and examples, but the present invention is not limited to only the examples described below.

In the Examples, apparatuses and conditions used for analysis of the physical properties of samples are as follows.

### (1) Measurement of molecular weight

The molecular weight of a polysiloxane used in the present invention is a molecular weight obtained in terms of polystyrene by GPC analysis.

Measurement was performed under GPC measurement conditions using a GPC apparatus (trade name: HLC-8220GPC, manufactured by Tosoh Corporation), a GPC column (trade name: Shodex (registered trademark) KF803L, KF802, KF801, manufactured by Showa Denko K.K.), a column temperature of 40°C, with tetrahydrofuran as an eluent (elution solvent), at a flow amount (flow rate) of 1.0 mL/min, with polystyrene (manufactured by Showa Denko K.K.) as a standard sample.

### (2) ¹H-NMR

The evaluation was performed using a nuclear magnetic resonance apparatus ¹H-NMR (400 MHz), manufactured by JEOL Ltd., and d6-Acetone as a solvent.

### (3) Film Thickness Measurement

The film thickness of each material was measured using an Ellipsometric Film Thickness Measurement System RE-3100 (manufactured by SCREEN Semiconductor Solutions Co., Ltd.).

The film thickness of the surface-modified layer precursor was measured as described below. The film thickness of a SiO₂ oxide film formed on a substrate was measured in advance, and then a surface modifier was applied to the substrate to form the surface-modified layer precursor. Thereafter, the film thickness was measured, and a difference between the film thickness before application of the modifier and the film thickness after application of the modifier was taken as the film thickness of the surface-modified layer precursor.

The film thickness of the surface-modified layer was measured as described below. The film thickness of a SiO₂ oxide film formed on a substrate was measured in advance, and then a surface modifier was applied to the substrate and thinned. Thereafter, the film thickness was measured, and a difference between the film thickness before application of the modifier and the film thickness after application of the modifier was taken as the film thickness of the surface-modified layer.

### [1] Synthesis of Monomer

### (Monomer Synthesis Example A)

In a 200 ml three-necked flask, 6.85 g of aminopropyltrimethoxysilane, 4.25 g of triethylamine, and 30 g of chloroform were put and stirred. Thereafter, 9.58 g of camphorsulfonyl chloride was added dropwise at room temperature, and the mixture was stirred at room temperature for 12 hours. After the reaction, the solution was filtered, and water was added to the filtrate to perform liquid separation. Thereafter, the organic layer was dried over sodium sulfate and filtered, and then the solvent was removed under reduced pressure to obtain a target compound (1) at 37% yield.

¹H-NMR(400MHz):0.69ppm(t, 2H), 0.88ppm(s, 3H), 1.01ppm(s, 3H), 1.38ppm(m, 1H), 1.69ppm(m, 2H), 1.87ppm(m, 2H), 1.98ppm(m, 1H), 2.10ppm(m, 1H), 2.22ppm(t, 1H), 2.34ppm(d, 1H), 2.87ppm(d, 1H), 3.07ppm(m, 2H), 3.34ppm(d, 1H), 3.50ppm(s, 9H), 5.36ppm(s, 1H) 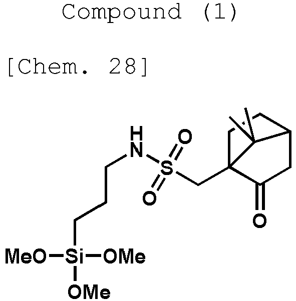 wherein Me represents a methyl group.

### (Monomer Synthesis Example B)

In a 200 ml three-necked flask, 11.85 g of N-methylaminopropyltrimethoxysilane, 6.83 g of triethylamine, and 45 g of chloroform were put and stirred. Thereafter, 15.00 g of 4-(trifluoromethyl)benzenesulfonyl chloride was added dropwise at room temperature, and the mixture was stirred at room temperature for 12 hours. After the reaction, the solution was filtered, and water was added to the filtrate to perform liquid separation. Thereafter, the organic layer was dried over sodium sulfate and filtered, and then the solvent was removed under reduced pressure to obtain a target compound (2) at 66% yield.

¹H-NMR (400MHz):0.53ppm(t, 2H), 1.51ppm(m, 2H), 2.70ppm(s, 3H), 2.97ppm(t, 2H), 3.45ppm(s, 9H), 7.66ppm(d, 2H), 7.72ppm(d, 2H) 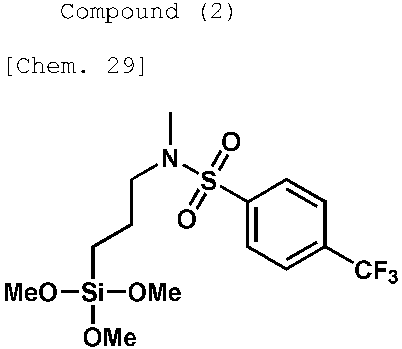 wherein Me represents a methyl group.

[2] Synthesis of Polymer (Hydrolysis Condensate) Compounds (1) to (13) used in each synthesis are shown below.

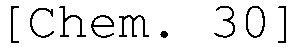

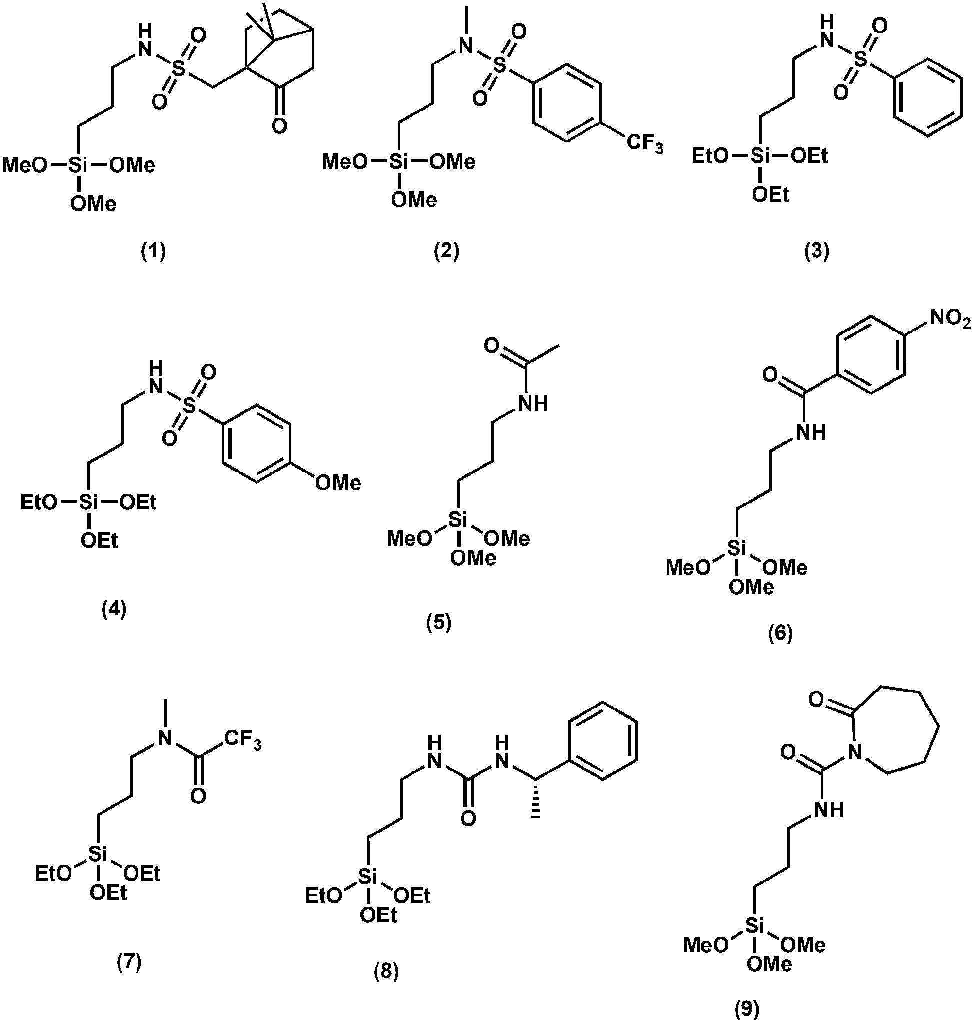

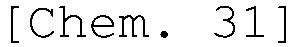

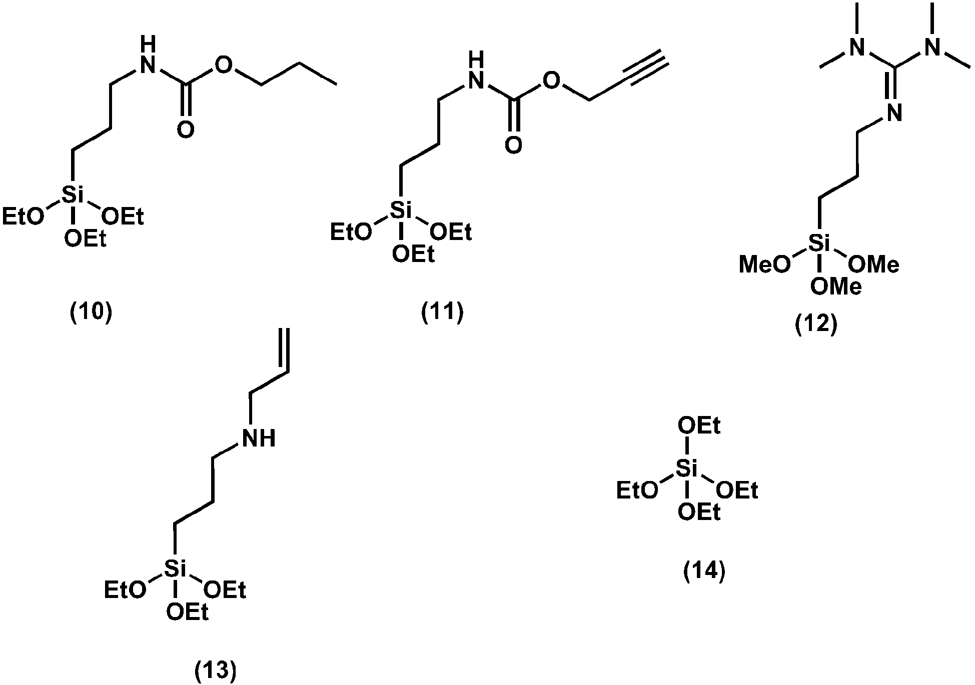

Me represents a methyl group. Et represents an ethyl group.

### (Synthesis Example 1)

In a 100-mL flask, 1.97 g of the compound (1) and 2.95 g of 1-ethoxy-2-propanol were charged and stirred, and 0.63 g of a 0.1 mol/L aqueous nitric acid solution was added dropwise thereto while stirring the resulting solution with a magnetic stirrer.

After the dropwise addition, the flask was transferred to an oil bath adjusted to 120°C, and the mixed solution was reacted for 20 hours. Thereafter, the reaction solution was cooled to room temperature, 10 g of 1-ethoxy-2-propanol was added to the reaction solution, and water and nitric acid, and methanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

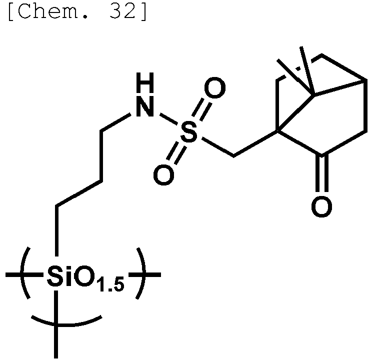

### (Synthesis Example 2)

In a 100-mL flask, 2.01 g of the compound (2) and 3.01 g of 1-ethoxy-2-propanol were charged and stirred, and 0.63 g of a 0.1 mol/L aqueous nitric acid solution was added dropwise thereto while stirring the resulting solution with a magnetic stirrer.

After the dropwise addition, the flask was transferred to an oil bath adjusted to 120°C, and the mixed solution was reacted for 20 hours. Thereafter, the reaction solution was cooled to room temperature, 10 g of 1-ethoxy-2-propanol was added to the reaction solution, and water and nitric acid, and methanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

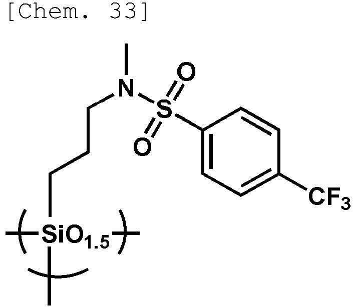

### (Synthesis Example 3)

In a 100-mL flask, 5.42 g of the compound (3) and 8.13 g of 1-ethoxy-2-propanol were charged and stirred, and 1.89 g of a 0.1 mol/L aqueous nitric acid solution was added dropwise thereto while stirring the resulting solution with a magnetic stirrer.

After the dropwise addition, the flask was transferred to an oil bath adjusted to 120°C, and the mixed solution was reacted for 20 hours. Thereafter, the reaction solution was cooled to room temperature, 10 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

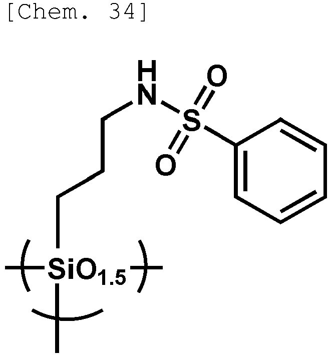

### (Synthesis Example 4)

In a 100-mL flask, 3.92 g of the compound (4) and 3.64 g of 1-ethoxy-2-propanol were charged and stirred, and 0.51 g of a 0.1 mol/L aqueous nitric acid solution was added dropwise thereto while stirring the resulting solution with a magnetic stirrer.

After the dropwise addition, the flask was transferred to an oil bath adjusted to 120°C, and the mixed solution was reacted for 20 hours. Thereafter, the reaction solution was cooled to room temperature, 10 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C. 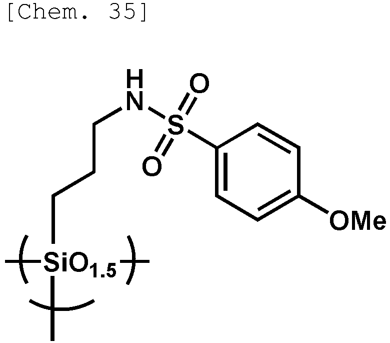 wherein Me represents a methyl group.

### (Synthesis Example 5)

In a 100-mL flask, 3.26 g of the compound (5) and 4.89 g of 1-ethoxy-2-propanol were charged and stirred, and 1.86 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 10 g of 1-ethoxy-2-propanol was added to the reaction solution, and water and nitric acid, and methanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

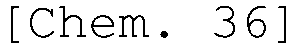

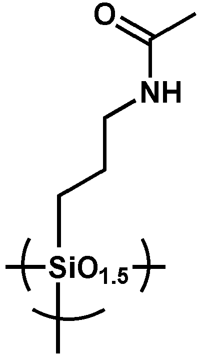

### (Synthesis Example 6)

In a 100-mL flask, 3.52 g of the compound (6) and 5.28 g of 1-ethoxy-2-propanol were charged and stirred, and 1.20 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 12 g of 1-ethoxy-2-propanol was added to the reaction solution, and water and nitric acid, and methanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

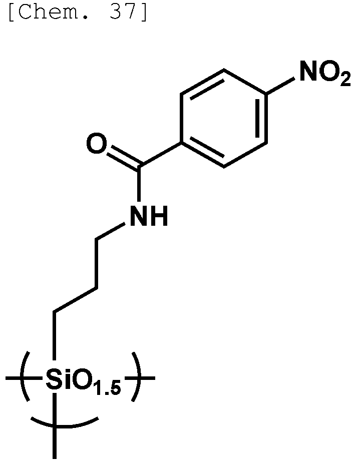

### (Synthesis Example 7)

In a 100-mL flask, 3.41 g of the compound (7) and 5.11 g of 1-ethoxy-2-propanol were charged and stirred, and 1.48 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 9 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

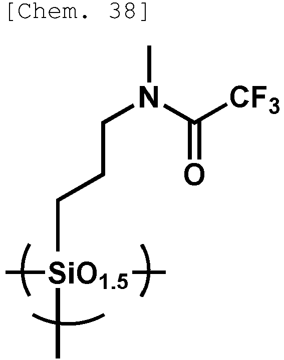

### (Synthesis Example 8)

In a 100-mL flask, 2.21 g of the compound (8) and 3.32 g of 1-ethoxy-2-propanol were charged and stirred, and 0.76 g of water was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 10 g of 1-ethoxy-2-propanol was added to the reaction solution, and water and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

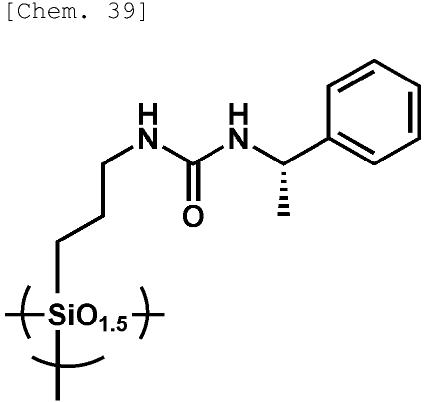

### (Synthesis Example 9)

In a 100-mL flask, 3.45 g of the compound (9) and 5.18 g of 1-ethoxy-2-propanol were charged and stirred, and 1.37 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 9 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

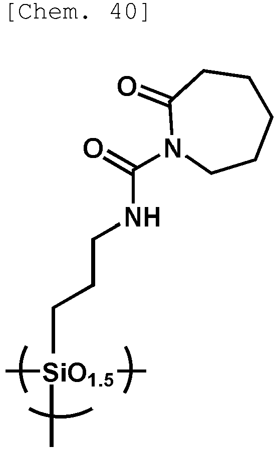

### (Synthesis Example 10)

In a 100-mL flask, 3.41 g of the compound (10) and 5.12 g of 1-ethoxy-2-propanol were charged and stirred, and 1.47 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 9 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

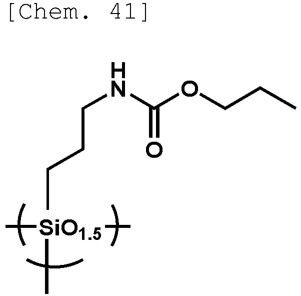

### (Synthesis Example 11)

In a 100-mL flask, 3.43 g of the compound (11) and 5.14 g of 1-ethoxy-2-propanol were charged and stirred, and 1.43 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 9 g of 1-ethoxy-2-propanol was added to the reaction solution, and water and nitric acid, and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

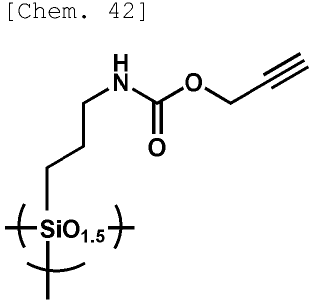

### (Synthesis Example 12)

In a 100-mL flask, 6.94 g of the compound (12) and 10.40 g of 1-ethoxy-2-propanol were charged and stirred, and 3.15 g of water was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 20 g of 1-ethoxy-2-propanol was added to the reaction solution, and water and methanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

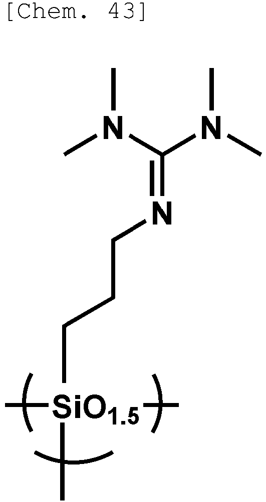

### (Synthesis Example 13)

In a 100-mL flask, 1.31 g of the compound (13) and 1.96 g of 1-ethoxy-2-propanol were charged and stirred, and 0.63 g of water was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 10 g of 1-ethoxy-2-propanol was added to the reaction solution, and water and ethanol as a reaction by-product were distilled off under reduced pressure to obtain a concentrated solution of a polymer (hydrolysis condensate) having a structure represented by the following formula using 1-ethoxy-2-propanol as a solvent. The solid content concentration of the obtained concentrated solution was more than 20 mass% in terms of solid residue when heated at 150°C.

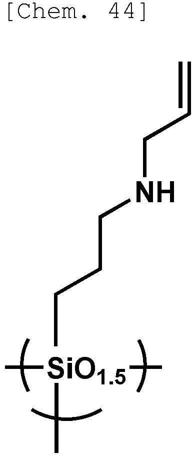

### (Comparative Synthesis Example 1)

In a 300-mL flask, 32.20 g of the compound (14) and 48.3 g of 1-ethoxy-2-propanol were charged and stirred, and 19.5 g of a 0.1 mol/L aqueous nitric acid solution was added dropwise thereto while stirring the resulting solution with a magnetic stirrer.

After the dropwise addition, the flask was transferred to an oil bath adjusted to 60°C, and the mixed solution was reacted for 20 hours. Thereafter, the reaction solution was cooled to room temperature, 50 g of 1-ethoxy-2-propanol was added to the reaction solution, and water and nitric acid, and ethanol as a reaction by-product were distilled off under reduced pressure to obtain a concentrated solution of a polymer (hydrolysis condensate) using 1-ethoxy-2-propanol as a solvent. The solid content concentration of the obtained concentrated solution was more than 20 mass% in terms of solid residue when heated at 150°C.

### [3] Preparation of Surface Modifier (Coating Liquid)

The polymer (hydrolysis condensate) obtained in the above Synthesis Example, additives and a solvent were mixed at a ratio shown in Table 1, and the mixture was filtered through a 0.02 µm polyethylene filter to prepare each surface modifier (coating liquid). In Table 1, the fact that each Synthesis Example described in the column of composition is 2 parts by mass means that the hydrolysis condensate is 2 parts by mass. In Table 1, MA means maleic acid, TPSNO3 means triphenylsulfonium nitrate, PTSA means paratoluenesulfonic acid, PGEE means propylene glycol monoethyl ether, and PGME means propylene glycol monomethyl ether.

**[Table 1]**

| | | Polymer | Additive 1 | Additive 2 | Additive 3 | Solvent | |
|---|---|---|---|---|---|---|---|
| Coating liquid 1 | Type | Synthesis Example 1 | MA | TPSNO3 | - | PGEE | PGME |
| | (parts by mass) | 2 | 0.02 | 0.01 | | 92 | 8 |
| Coating liquid 2 | Type | Synthesis Example 2 | MA | TPSNO3 | - | PGEE | PGME |
| | (parts by mass) | 2 | 0.02 | 0.01 | | 92 | 8 |
| Coating liquid 3 | Type | Synthesis Example 3 | MA | TPSNO3 | - | PGEE | PGME |
| | (parts by mass) | 2 | 0.02 | 0.01 | | 92 | 8 |
| Coating liquid 4 | Type | Synthesis Example 4 | MA | TPSNO3 | - | PGEE | PGME |
| | (parts by mass) | 2 | 0.02 | 0.01 | | 92 | 8 |
| Coating liquid 5 | Type | Synthesis Example 5 | MA | TPSNO3 | - | PGEE | PGME |
| | (parts by mass) | 2 | 0.02 | 0.01 | | 92 | 8 |
| Coating liquid 6 | Type | Synthesis Example 6 | MA | TPSNO3 | - | PGEE | PGME |
| | (parts by mass) | 2 | 0.02 | 0.01 | | 92 | 8 |
| Coating liquid 7 | Type | Synthesis Example 7 | MA | TPSNO3 | - | PGEE | PGME |
| | (parts by mass) | 2 | 0.02 | 0.01 | | 92 | 8 |
| Coating liquid 8 | Type | Synthesis Example 8 | MA | TPSNO3 | - | PGEE | PGME |
| | (parts by mass) | 2 | 0.02 | 0.01 | | 92 | 8 |
| Coating liquid 9 | Type | Synthesis Example 9 | MA | TPSNO3 | - | PGEE | PGME |
| | (parts by mass) | 2 | 0.02 | 0.01 | | 92 | 8 |
| Coating liquid 10 | Type | Synthesis Example 10 | MA | TPSNO3 | - | PGEE | PGME |
| | (parts by mass) | 2 | 0.02 | 0.01 | | 92 | 8 |
| Coating liquid 11 | Type | Synthesis Example 11 | MA | TPSNO3 | - | PGEE | PGME |
| | (parts by mass) | 2 | 0.02 | 0.01 | | 92 | 8 |
| Coating liquid 12 | Type | Synthesis Example 12 | MA | TPSNO3 | - | PGEE | PGME |
| | (parts by mass) | 2 | 0.02 | 0.01 | | 92 | 8 |
| Coating liquid 13 | Type | Synthesis Example 12 | MA | TPSNO3 | PTSA | PGEE | PGME |
| | (parts by mass) | 2 | 0.02 | 0.01 | 1.65 | 92 | 8 |
| Coating liquid 14 | Type | Synthesis Example 12 | MA | TPSNO3 | Sorbic acid | PGEE | PGME |
| | (parts by mass) | 2 | 0.02 | 0.01 | 1.08 | 92 | 8 |
| Coating liquid 15 | Type | Synthesis Example 12 | MA | TPSNO3 | Methacrylic acid | PGEE | PGME |
| | (parts by mass) | 2 | 0.02 | 0.01 | 0.83 | 92 | 8 |
| Coating liquid 16 | Type | Synthesis Example 13 | MA | TPSNO3 | - | PGEE | PGME |
| | (parts by mass) | 2 | 0.02 | 0.01 | | 92 | 8 |
| Comparative coating liquid 1 | Type | Comparative Synthesis Example 1 | MA | TPSNO3 | - | PGEE | PGME |
| | (parts by mass) | 2 | 0.02 | 0.01 | | 92 | 8 |

### [4] Thinning Evaluation

The coating liquids 1 to 16 and the comparative coating liquid 1 were each applied onto a silicon wafer using a spinner, and heated on a hot plate at a baking temperature shown in Table 2 for 60 seconds to form a surface-modified layer precursor. Thereafter, a mixed solvent of propylene glycol monomethyl ether/propylene glycol monomethyl ether acetate (7/3 (V/V)) was applied onto each of the surface-modified layer precursors, and then left to stand for 60 seconds. Thereafter, each of the wafers was rotated to shake off the solvent, baked at 100°C for 30 seconds, and dried. Thereafter, the film thickness of the obtained surface-modified layer was measured, and a case where the film thickness could be reduced to 30Å or less was rated as "good", and a case where the film thickness could not be reduced to 30Å or less was rated as "poor". The results are shown in Table 2.

**[Table 2]**

| No. | Coating liquid | Baking temperature (°C) | Thinning evaluation |
|---|---|---|---|
| Example 1 | Coating liquid 1 | 160 | Good |
| Example 2 | Coating liquid 2 | 215 | Good |
| Example 3 | Coating liquid 3 | 215 | Good |
| Example 4 | Coating liquid 4 | 180 | Good |
| Example 5 | Coating liquid 5 | 180 | Good |
| Example 6 | Coating liquid 6 | 120 | Good |
| Example 7 | Coating liquid 7 | 180 | Good |
| Example 8 | Coating liquid 8 | 180 | Good |
| Example 9 | Coating liquid 9 | 160 | Good |
| Example 10 | Coating liquid 10 | 215 | Good |
| Example 11 | Coating liquid 11 | 180 | Good |
| Example 12 | Coating liquid 12 | 100 | Good |
| Example 13 | Coating liquid 13 | 160 | Good |
| Example 14 | Coating liquid 14 | 100 | Good |
| Example 15 | Coating liquid 15 | 100 | Good |
| Example 16 | Coating liquid 16 | 100 | Good |
| Comparative Example 1 | Comparative coating liquid 1 | 215 | Poor |

### [5] Surface Modification Evaluation

The coating liquids 1 to 16 and the comparative coating liquid 1 were each applied onto Bare-Si using a spinner, and heated on a hot plate at a baking temperature shown in Table 3 for 60 seconds to form a surface-modified layer precursor. Thereafter, a mixed solvent of propylene glycol monomethyl ether/propylene glycol monomethyl ether acetate (7/3 (V/V)) was applied onto each of the surface-modified layer precursors, and then spin-dried. The water contact angle of the obtained surface-modified layer was measured to evaluate whether the substrate surface could be modified. The water contact angle was measured using a fully automatic contact angle meter DM-701 (manufactured by Kyowa Interface Science Co., Ltd.). A droplet volume of 3 µL was used, and the measurement was taken 5 seconds after the droplet was placed. Since the water contact angle of Bare-Si was 20 degrees or less, when the water contact angle was less than 30 degrees, it was determined that the surface modification was not completed, and evaluated as "poor". On the other hand, when the water contact angle was 30 degrees or more, it was determined that hydrophobization, that is, surface modification could be performed by the partial structure of the surface modifier, and evaluated as "good". The obtained evaluation results are shown in Table 3.

**[Table 3]**

| No. | Coating liquid | Baking temperature (°C) | Surface modification evaluation |
|---|---|---|---|
| Example 17 | Coating liquid 1 | 160 | Good |
| Example 18 | Coating liquid 2 | 215 | Good |
| Example 19 | Coating liquid 3 | 215 | Good |
| Example 20 | Coating liquid 4 | 180 | Good |
| Example 21 | Coating liquid 5 | 180 | Good |
| Example 22 | Coating liquid 6 | 120 | Good |
| Example 23 | Coating liquid 7 | 180 | Good |
| Example 24 | Coating liquid 8 | 180 | Good |
| Example 25 | Coating liquid 9 | 160 | Good |
| Example 26 | Coating liquid 10 | 215 | Good |
| Example 27 | Coating liquid 11 | 180 | Good |
| Example 28 | Coating liquid 12 | 100 | Good |
| Example 29 | Coating liquid 13 | 160 | Good |
| Example 30 | Coating liquid 14 | 100 | Good |
| Example 31 | Coating liquid 15 | 100 | Good |
| Example 32 | Coating liquid 16 | 100 | Good |
| Comparative Example 2 | Comparative coating liquid 1 | 215 | Poor |

### [6] EUV Patterning Evaluation Using Metal Resist

### [6-1] Evaluation of pattern shape

The coating liquids 1 and 3 to 16 and the comparative coating liquid 1 were each applied onto a silicon wafer using a spinner, and heated on a hot plate at a baking temperature shown in Table 4 for 60 seconds to form a surface-modified layer precursor. Thereafter, a mixed solvent of propylene glycol monomethyl ether/propylene glycol monomethyl ether acetate (7/3 (V/V)) was applied onto each of the surface-modified layer precursors, and then spin-dried. Thereafter, a metal resist (metal oxide resist) solution was applied onto the obtained surface-modified layer, and heated at 100°C for 60 seconds to form a metal resist film. Thereafter, exposure was performed under the conditions of NA=0.33 and σ=0.595/0.817 using an EUV exposure apparatus (NXE3400) manufactured by ASML.

After the exposure, heating after exposure (PEB) was performed at 180°C for 60 seconds, cooling was performed on a cooling plate to room temperature, and development and rinsing were performed with an organic solvent developer. Thereafter, heating was performed at 250°C for 60 seconds to form a resist pattern. In the obtained pattern, pattern observation of 14 nm line/28 nm pitch (line and space (L/S) = 1/1) was performed, and a state in which no pinhole in the pattern portion or residue in the space portion was observed was evaluated as "good", and a state in which a pattern error such as a pinhole in the pattern portion was observed was evaluated as "poor". The evaluation results are shown in Table 4.

### [6-2] Evaluation of exposure sensitivity

In the EUV patterning evaluation of [6-1] above, the exposure amount at which a 14 nm line/28 nm pitch (line and space (L/S) = 1/1) was formed was defined as the optimum exposure amount, and the exposure sensitivity was evaluated. When the optimum exposure amount in the case of using Comparative coating liquid 1 was 100%, the case where the optimum exposure amount reduced by 2% or more, that is, the case where the exposure sensitivity was improved was evaluated as "good". In addition, among those evaluated as "good", a case where the reduction rate of the optimum exposure amount was 20% or more, that is, a case where further improvement in exposure sensitivity was observed was evaluated as "very good". The evaluation results are shown in Table 4.

**[Table 4]**

| No. | Coating liquid | Baking temperature (°C) | Pattern shape | Exposure sensitivity |
|---|---|---|---|---|
| Example 33 | Coating liquid 6 | 120 | Good | Good |
| Example 34 | Coating liquid 10 | 215 | Good | Good |
| Example 35 | Coating liquid 13 | 160 | Good | Good |
| Example 36 | Coating liquid 1 | 160 | Good | Very good |
| Example 37 | Coating liquid 3 | 215 | Good | Very good |
| Example 38 | Coating liquid 4 | 180 | Good | Very good |
| Example 39 | Coating liquid 5 | 180 | Good | Very good |
| Example 40 | Coating liquid 7 | 180 | Good | Very good |
| Example 41 | Coating liquid 8 | 180 | Good | Very good |
| Example 42 | Coating liquid 9 | 160 | Good | Very good |
| Example 43 | Coating liquid 11 | 180 | Good | Very good |
| Example 44 | Coating liquid 12 | 100 | Good | Very good |
| Example 45 | Coating liquid 14 | 100 | Good | Very good |
| Example 46 | Coating liquid 15 | 100 | Good | Very good |
| Example 47 | Coating liquid 16 | 100 | Good | Very good |
| Comparative Example 3 | Comparative coating liquid 1 | 215 | Poor | Reference (100%) |

## Claims

1. A method for producing a laminate having a surface-modified layer and a semiconductor substrate, the method comprising:
a first step of applying a surface modifier containing a polysiloxane (A) having an organic group having a nitrogen atom and a solvent (B) to the semiconductor substrate, and then baking the semiconductor substrate to form a surface-modified layer precursor; and
a second step of bringing the surface-modified layer precursor into contact with a thinning liquid (X) to thin the surface-modified layer precursor and to form the surface-modified layer having a film thickness of 5 nm or less.

2. The method for producing a laminate according to claim 1, wherein the nitrogen atom is any one of a nitrogen atom (N¹) constituting an amide bond, a nitrogen atom (N²) constituting a sulfonamide bond, a nitrogen atom (N³) constituting a guanidine structure, and a nitrogen atom (N⁴) other than the N¹ to N³, which is bonded to at least one carbon atom and the bond is a single bond.

3. The method for producing a laminate according to claim 1, wherein the organic group having a nitrogen atom is a group that binds to a silicon atom and is a monovalent group represented by any one of the following formulas (21) to (Z4): 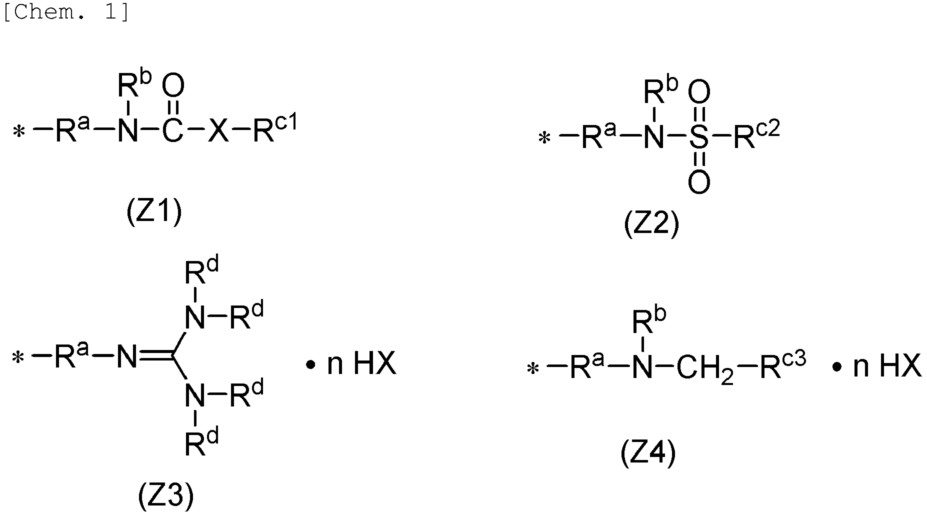
wherein R^{a} each independently represents a single bond or a divalent group having 1 to 6 carbon atoms;
R^{d} each independently represents a hydrogen atom or a monovalent group having 1 to 6 carbon atoms;
R^{c1} to R^{c3} each independently represent a monovalent group having 1 to 20 carbon atoms;
X represents a single bond, -O- or -N(R^{e})-, where R^{e} represents a hydrogen atom or a monovalent group having 1 to 6 carbon atoms, and when X is -N(R^{e})-, R^{e} and R^{c2} may be taken together to form a ring structure having 5 to 7 carbon atoms;
R^{d} each independently represents a hydrogen atom or a monovalent group having 1 to 20 carbon atoms;
n each independently represents 0 or a positive number; HX represents an acid; and
* represents a bond.

4. The method for producing a laminate according to claim 1, wherein the polysiloxane is a hydrolysis condensate of a hydrolyzable silane containing a compound represented by the following formula (A): 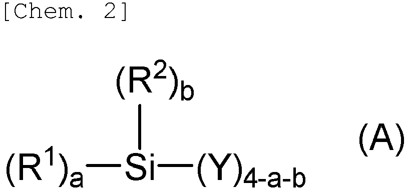
wherein R¹ is a group bonded to a silicon atom, and each independently represents an organic group having a nitrogen atom;
R² is a group bonded to a silicon atom, and each independently represents an optionally substituted alkyl group, an optionally substituted aryl group, an optionally substituted aralkyl group, an optionally substituted alkyl halide group, an optionally substituted aryl halide group, an optionally substituted aralkyl halide group, an optionally substituted alkoxyalkyl group, an optionally substituted alkoxyaryl group, an optionally substituted alkoxyaralkyl group, or an optionally substituted alkenyl group, or an organic group having an optionally ring-opened epoxy group, an organic group having an acryloyl group, an organic group having a methacryloyl group, an organic group having a mercapto group, an organic group having an alkoxy group, an organic group having a sulfonyl group, or an organic group having a cyano group, or a combination of two or more of these groups;
Y is a group or atom bonded to a silicon atom, and each independently represents an alkoxy group, an aralkyloxy group, an acyloxy group, or a halogen atom;
a represents an integer of 1 to 3; b represents an integer of 0 to 2; and a+b is 1 to 3.

5. The method for producing a laminate according to claim 4, wherein R¹ in the formula (A) is a monovalent group represented by any one of the following formulas (Z1) to (Z4): 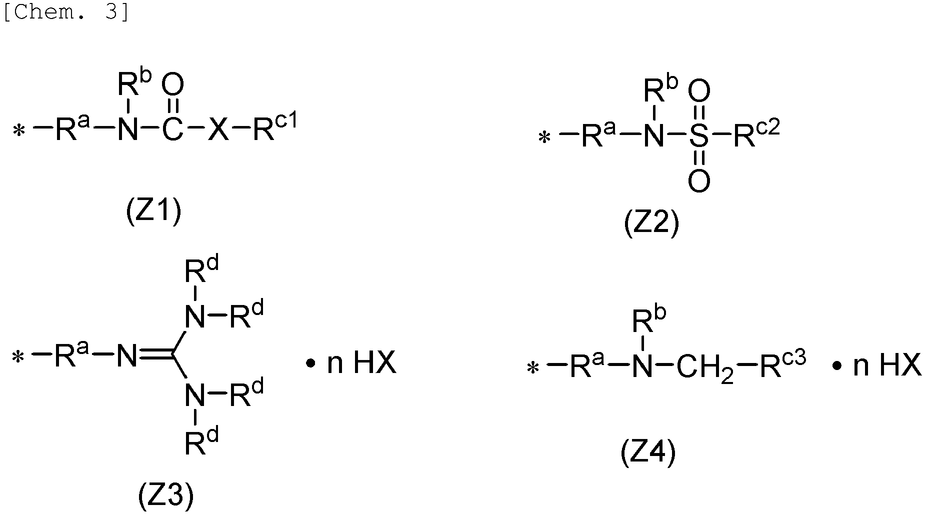
wherein R^{a} each independently represents a single bond or a divalent group having 1 to 6 carbon atoms;
R^{b} each independently represents a hydrogen atom or a monovalent group having 1 to 6 carbon atoms;
R^{c1} to R^{c3} each independently represent a monovalent group having 1 to 20 carbon atoms;
X represents a single bond, -O- or -N(R^{e})-, where R^{e} represents a hydrogen atom or a monovalent group having 1 to 6 carbon atoms, and when X is -N(R^{e})-, R^{e} and R^{c2} may be taken together to form a ring structure having 5 to 7 carbon atoms;
R^{d} each independently represents a hydrogen atom or a monovalent group having 1 to 20 carbon atoms;
n each independently represents 0 or a positive number; HX represents an acid; and
* represents a bond.

6. The method for producing a laminate according to claim 1, wherein the solvent (B) includes at least one selected from the group consisting of a carboxylic acid having a hydroxy group, a linear or cyclic alkyl ketone, a cyclic lactone, an alkylene glycol monoalkyl ether, a monocarboxylic acid ester of an alkylene glycol monoalkyl ether, and an alkoxycarboxylic acid ester of an alkylene glycol monoalkyl ether.

7. The method for producing a laminate according to claim 1, wherein the thinning liquid (X) includes at least one of an organic solvent and water.

8. The method for producing a laminate according to claim 1, wherein the surface modifier further contains a curing catalyst (C).

9. The method for producing a laminate according to claim 1, wherein the semiconductor substrate is a substrate of an inorganic or organic material or a substrate having a film of an inorganic or organic material.

10. The method for producing a laminate according to claim 9, wherein the inorganic material is at least one selected from the group consisting of a metal, a metal oxide, a metal nitride, a metal carbide, a metal oxynitride, a metal oxycarbide, and a metal carbonitride.

11. The method for producing a laminate according to claim 9, wherein the organic material is at least one selected from the group consisting of amorphous carbon, graphite, fullerene, carbon nanotube, diamond, diamond-like carbon, polyimide, and an organic film in which any one of them is doped or partially substituted with boron, oxygen, nitrogen, phosphorus, silicon, sulfur, or halogen.

12. The method for producing a laminate according to claim 1, wherein the laminate further has a resist underlayer film.

13. The method for producing a laminate according to claim 1, wherein the second step is a step of spin-coating the surface-modified layer precursor with the thinning liquid (X) to thin the surface-modified layer precursor and to form the surface-modified layer having a film thickness of 5 nm or less.

14. The method for producing a laminate according to claim 1, wherein the laminate is used in EUV lithography or electron beam lithography.

15. The method for producing a laminate according to claim 1, wherein the laminate is used in EUV lithography using a metal-containing resist film.

16. A method for producing a semiconductor element, the method comprising:
a step of forming a resist film on the laminate formed by the method for producing a laminate according to any one of claims 1 to 15; and
a step of exposing and developing the resist film to form a resist pattern.

17. The method for producing a semiconductor element according to claim 16, wherein the resist film is a metal-containing resist film.

18. A laminate comprising: a semiconductor substrate; and a surface-modified layer formed using a surface modifier containing a polysiloxane (A) having an organic group having a nitrogen atom and a solvent (B) and having a film thickness of 5 nm or less.

19. The laminate according to claim 18, which is used in EUV lithography or electron beam lithography.

20. The laminate according to claim 18, which is used in EUV lithography using a metal-containing resist film.

21. A surface modifier comprising: a polysiloxane (A) having an organic group having a nitrogen atom; and a solvent (B), wherein
the surface modifier is used in the method for producing a laminate according to any one of claims 1 to 15.

22. A compound represented by the following formula (T1) : 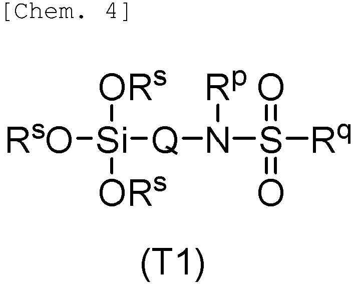
wherein Q represents a divalent group having 1 to 6 carbon atoms;
R^{p} represents a hydrogen atom or an alkyl group having 1 to 3 carbon atoms;
R^{q} represents a monovalent group represented by the following formula (R^{q}-1) or (R^{q}-2); and
R^{s} each independently represents an alkyl group having 1 to 3 carbon atoms, 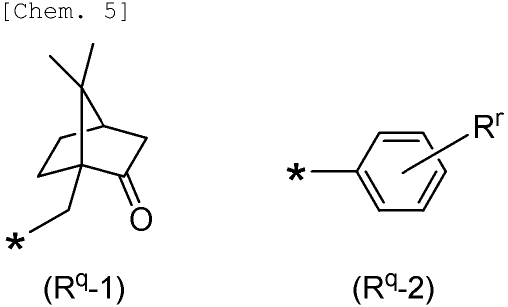
wherein * each represents a bond; and
in the formula (R^{q}-2), R^{r} represents a perfluoroalkyl group having 1 to 3 carbon atoms, a difluoromethyl group, an iodine atom, an OH group, or a nitro group.
